Europäisches Patentamt

(19) European Patent Office

Office européen des brevets

(11) Veröffentlichungsnummer: **0 011 899**
**B1**

(12) **EUROPÄISCHE PATENTSCHRIFT**

(45) Veröffentlichungstag der Patentschrift:
**20.10.82**

(51) Int. Cl.³: **H 03 K 4/50**, H 04 N 3/16

(21) Anmeldenummer: **79200687.6**

(22) Anmeldetag: **22.11.79**

(54) Schaltungsanordnung zum Erzeugen einer synchronisierbaren Sägezahnspannung.

(30) Priorität: **27.11.78 NL 7811597**
**13.07.79 DE 2928264**

(43) Veröffentlichungstag der Anmeldung:
**11.06.80 Patentblatt 80/12**

(45) Bekanntmachung des Hinweises auf die Patenterteilung:
**20.10.82 Patentblatt 82/42**

(84) Benannte Vertragsstaaten:
**AT BE CH DE FR GB IT NL SE**

(56) Entgegenhaltungen:
**CITED DOCUMENTS (56):**

**FR-A-2 305 065**

**ELEKTRONIK, Band 23, Heft 10, Oktober 1974, München, DE, W. WISOTZKY: ,,COS/MOS-gatter schalten Sägezahn-Generator'', Seiten 376-378**
**WIRELESS WORLD, Band 77, Heft 1434 Dezember 1971, London, GB, J. CAIRNS: ,,Linear ramp generator'' Seiten 604-605.**
**FUNK-TECHNIK, Jahrgang 31, Heft 9, Mai 1976, München, DE, L. FREYBERGER: ,,Integrierte Bildkippschaltung für Fernsehempfänger'', Seiten 260, 262-265, 268.** →

(73) Patentinhaber: **N.V. Philips' Gloeilampenfabrieken,**
**Groenewoudseweg 1, NL-5621 BA Eindhoven (NL)**

(84) Benannte Vertragsstaaten: **BE CH FR GB IT NL SE AT**

(73) Patentinhaber: **Philips Patentverwaltung GmbH,**
**Steindamm 94, D-2000 Hamburg 1 (DE)**

(84) Benannte Vertragsstaaten: **DE**

(72) Erfinder: **Duijkers, Peter Antoon, c/o INT.**
**OCTROOIBUREAU B.V. Prof. Holstlaan 6, NL- 5656 AA Eindhoven (NL)**
Erfinder: **Sonnenberger, Paul, c/o INT.**
**OCTROOIBUREAU B.V. Prof. Holstlaan 6, NL- 5656 AA Eindhoven (NL)**

(74) Vertreter: **Minczeles, Roger et al, INTERNATIONAAL OCTROOIBUREAU B.V. Prof. Holstlaan 6, NL-5656 AA Eindhoven (NL)**

→ **ELEKTOR, Band 4, Heft 6, Juni 1978, Canterbury, GB, ,,Constant amplitude squarewave to sawtooth converter'', Seiten 6-14 bis 6-16.**
**IEEE TRANSACTIONS ON CONSUMER ELECTRONICS, Band CE-24, Heft 3, August 1978, New York, US, S. COCCETTI: ,,New developments in integrated horizontal processors for TV'', Seiten 274-283.**

Schaltungsanordnung zum Erzeugen einer synchronisierbaren Sägezahnspannung

Die Erfindung bezieht sich auf eine Schaltungsanordnung zum Erzeugen einer Sägezahnspannung an einem Kondensator, der durch einen ersten Strom aufgeladen wird, bis eine erste Schwellenspannung erreicht ist, und der durch einen zweiten Strom entladen wird, bis eine zweite Schwellenspannung erreicht ist, wobei im Zeitpunkt des Erreichens einer Schwellenspannung die Richtung und gegebenenfalls die Stärke des dem Kondensator zugeführten Stromes umgeschaltet wird und wobei der Unterschied zwischen der ersten und der zweiten Schwellenspannung sowie der Auflage- und der Entladestrom die Eigenfrequenz der erzeugten Sägezahnspannung bestimmen, wobei einer der Umschaltzeitpunkte der Kondensatorladung durch zugeführte Synchronsignale mit einer nahezu konstanten Nennwiederholungsfrequenz bestimmbar und damit die Sägezahnspannung durch die Synchronsignale synchronisierbar ist.

Eine derartige Schaltungsanordnung ist aus „Elektronik", Band 23, Heft 10, Oktober 1974, München, DE, W. Wisotzky: „COS/MOS-Gatter schalten sägezahn-Generator" Seiten 376-378, bekannt. Dieser bekannte Sägezahngenerator ist durch zugeführte Synchronsignale synchronisierbar und er kann zwischen periodischen Betrieb und einmaliger Ablenkung von Hand umgeschaltet werden. Der Erfindung liegt die Aufgabe zugrunde, eine Schaltungsanordnung der eingangs erwähnten Art so auszubilden, dass in einem Zustand eine einer Norm entsprechende Eigenfrequenz für die erzeugte Sägezahnspannung, während in einem anderen Zustand für direkte Synchronisierung eine andere Frequenz bzw. eine einer anderen Norm entsprechende Eigenfrequenz erhalten wird.

Die erfindungsgemässe Schaltungsanordnung weist das Kennzeichen auf, dass die Eigenfrequenz der erzeugten Sägezahnspannung unter dem Einfluss eines automatischen Synchronsignaldetektors, der das Vorhandensein und/oder die Frequenz des Synchronsignals prüft, umschaltbar ist.

Unter Nennfrequenz wird diejenige Frequenz verstanden, die die Impulse des Synchronsignals, z.B. entsprechend einer Norm aufweisen sollen, obschon sie in der Praxis infolge von Toleranzen davon etwas abweichen können.

In einer vorteilhaften Ausführung der Schaltungsanordnung nach der Erfindung weist diese das Kennzeichen auf, dass durch den Synchronsignaldetektor das Vorhandensein der Synchronsignale festgestellt wird, und dass beim Fehlen des Synchronsignals ein erster Schaltzustand, in dem die Eigenfrequenz der Sägezahnspannung der Nennwiederholungsfrequenz des Synchronsignals nahezu entspricht, und beim Vorhandensein des Synchronsignals ein zweiter Schaltzustand, in dem die Eigenfrequenz der Sägezahnspannung niedriger ist als die genannte Nennwiederholungsfrequenz, hergestellt wird.

Die genannte Massnahme bietet den Vorteil, dass der Oszillator auf einfache Weise eingestellt werden kann, da die Frequenz desselben ohne Synchronsignal dieselbe ist wie die Frequenz mit Synchronsignal im synchronisierten Zustand. Ausserdem behält, wenn das Synchronsignal aus irgendeinem Grund vorübergehend fortfällt, der Oszillator nahezu die Nennfrequenz dieses Signals nach wie vor bei.

Ändert jedoch die Eigenfrequenz des Oszillators beim Fehlen des Synchronsignals, z.B. infolge von Toleranzen, Alterung von Elementen oder infolge von Temperatureffekten auf derartige Weise, dass die Eigenfrequenz einen Wert annimmt, der höher ist als der Nennwert, so wäre der Oszillator ohne weitere Massnahme nicht mehr synchronisierbar. Die Periode der Sägezahnform ist nun ja kürzer als das Zeitintervall zwischen zwei aufeinanderfolgenden Synchronimpulsen. Dank der erwähnten Massnahme wird also ein direktes Synchronisieren, auch wenn die Eigenfrequenz der erzeugten sägezahnförmigen Spannung höher ist als die der Synchronimpulse, ermöglicht.

Verschiedene Fernsehnormen haben unterschiedliche Ablenkfrequenzen, insbesondere in der Vertikalablenkung; so arbeitet z.B. die europäische Fernsehnorm mit 50 Hz, also einer Periode von 20 ms, während die US-Fernsehnorm 60 Hz, entsprechend einer Periode von 16,67 ms, benutzt. Für Empfänger, die sowohl in dem einen wie in dem anderen Fernsehempfangsgebiet benutzt werden sollen, ist daher eine Umschaltung erforderlich. Z.B. können in Süddeutschland Fernsehsignale beider Normen am gleichen Ort empfangen werden, weil dort von den amerikanischen Truppen auch Sender betrieben werden, die nach dem NTSC-System mit 60 Hz Bildablenkung arbeiten.

Hinsichtlich der Ablenkfrequenz ist daher für übliche Fernsehempfänger keine besondere Schaltungsanordnung erforderlich, weil die Zeilenfrequenz beider Normen fast gleich ist und bei Direktsynchronisierung der 60 Hz-Bildwechselimpuls zwar etwas früher eintrifft, aber einen normalen Rückschlag einleitet. Da jedoch diese Synchronisierung auf einer ansteigenden Sägezahnflanke zu einem früheren Zeitpunkt und damit bei einer niedrigeren Amplitude erfolgt, ist dadurch die Amplitude der Vertikalablenkung im Verhältnis der Perioden, also um etwa 17% vermindert, so dass die Bildgeometrie entsprechend verzerrt ist.

Es ist eine weitere Erkenntnis der Erfindung, dass der Synchronsignaldetektor auch derart benutzt werden kann, dass bei einer anderen Frequenz des Synchronsignals der Sägezahngenerator so umgeschaltet werden kann, dass die Sägezahnamplitude annähernd gleich bleibt. Dazu weist die Schaltungsanordnung nach der Erfindung das Kennzeichen auf, dass mittels des Synchronsignaldetektors festgestellt wird, ob die Frequenz der Synchronimpulse einem ersten niedrigeren oder einem zweiten höheren Wert entspricht und dass beim zweiten Frequenzwert der Aufladestrom und gegebenenfalls der Entladestrom des Sägezahnkondensators erhöht wird, derart, dass bei beiden Frequenzen die Amplitude der Sägezahnspannung etwa gleich gross ist.

Die Erfindung wird nachstehend an Hand der Zeichnung beispielsweise näher erläutert, in der

Fig. 1 eine erste Ausführungsform der erfindungsgemässen Schaltungsanordnung,

Fig. 2 Wellenformen, die in der Schaltungsanordnung nach der Erfindung auftreten,

Fig. 3 eine zweite Ausführungsform der erfindungsgemässen Schaltungsanordnung,

Fig. 4 ein Blockschaltbild einer Anwendungsmöglichkeit der erfindungsgemässen Schaltungsanordnung,

Fig. 5 ein Blockschaltbild einer dritten Ausführungsform der erfindungsgemässen Schaltungsanordnung,

Fig. 6 den Verlauf einer in der Schaltungsanordnung nach Fig. 5 auftretenden Sägezahnspannung, und

Fig. 7 ein detailliertes Ausführungsbeispiel der Schaltungsanordnung nach Fig. 5 darstellt.

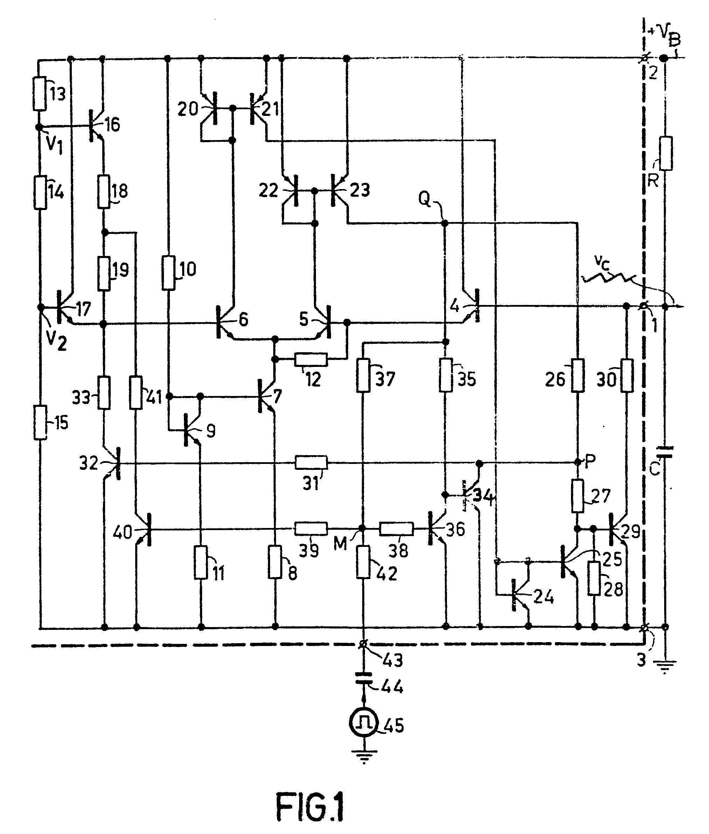

Der in Fig. 1 dargestellte Sägezahnoszillator bildet einen Teil eines innerhalb einer gestrichelten Linie dargestellten Halbleiterkörpers, in dem alle Elemente des Oszillators mit Ausnahme eines Kondensators C und ggf. eines Widerstandes R integriert sind. Der Widerstand R und der Kondensator C bilden eine Reihenschaltung, die zwischen den Klemmen einer Speisespannungsquelle $V_B$ angeordnet ist. Die Klemme 1 ist mit dem Verbindungspunkt des Widerstandes R und des Kondensators C verbunden, während eine Klemme 2 mit der positiven Klemme und eine Klemme 3 mit der negativen Klemme der Quelle $V_B$ und zugleich mit Masse verbunden ist.

Die Klemme 1 ist über einen Emitterfolgertransistor 4 mit der Basis eines Transistors 5 verbunden. Es sei bemerkt, dass die Transistoren in den Figuren mit Ausnahme einiger nachstehend genannten Transistoren vom npn-Typ sind. Mit einem weiteren Transistor 6 bildet der Transistor 5 eine Vergleichsstufe. Dazu sind die Emitter der Transistoren 5 und 6 miteinander sowie mit dem Kollektor eines als Stromquelle wirksamen Transistors 7 verbunden. Die Basis dieses Transistors 7 ist mit der Basis und dem Kollektor eines Transistors 9 verbunden und zugleich mit einem Widerstand 10, der andererseits an die Spannung $V_B$ gelegt ist. Der Emitter des Transistor 9 liegt über einen Widerstand 11 an Masse. Auch zwischen den Emitter des Transistors 7 und Masse ist ein Widerstand 8 eingeschaltet. Die Transistoren 9 und 7 bilden eine Stromspiegelschaltung derart, dass durch den Widerstand 8 ein etwa konstanter Strom fliesst, der dem Strom durch den Widerstand 10 proportional ist. Ein Widerstand 12, der zum Teil den Emitterstrom des Transistor 4 führt, liegt parallel zur Basisemitterstrecke des Transistors 5 zum Verbessern der Ausschalteigenschaften des Transistors 4.

Zwischen den Speiseklemmen 2 und 3 ist die Reihenschaltung aus drei Widerständen 13, 14 und 15 aufgenommen. Der Verbindungspunkt der Widerstände 13 und 14, der im Betrieb eine Spannung $V_1$ führt, ist mit der Basis eines Transistors 16 verbunden, während der Verbindungspunkt der Widerstände 14 und 15, der im Betrieb eine Spannung $V_2$ führt, die niedriger ist als die Spannung $V_1$, mit der Basis eines Transistors 17 verbunden ist. Der Emitter des Transistors 17 liegt unmittelbar an der Basis des Transistors 6 und ist über zwei reihengeschaltete Widerstände 18 und 19 mit dem Emitter des Transistors 16 verbunden, während die Kollektoren der Transistoren 4, 16 und 17 an der Spannung $+V_B$ liegen.

Der Kollektor des Transistors 6 ist mit den Basen zweier erster pnp-Transistoren 20 und 21 verbunden, deren Emitter an der Spannung $+V_B$ liegen. Auf gleiche Weise ist der Kollektor des Transistors 5 mit den Basen zweier zweiter pnp-Transistoren 22 und 23 verbunden, deren Emitter an der Spannung $V_B$ liegen. Der Kollektor und die Basis des Transistors 20 bzw. 22 sind zusammengeschaltet. Der Kollektor des Transistors 21 ist mit der Basis und dem Kollektor eines Transistors 24 und zugleich mit der Basis eines weiteren Transistors 25 verbunden; die Emitter der Transistoren 24 und 25 liegen an Masse. Der Kollektor des Transistors 23 ist mit einem Potentialpunkt Q und weiter über einen Widerstand 26 mit einem Potentialpunkt P verbunden. Der Kollektor des Transistors 25 ist über einen Widerstand 27 ebenfalls an den Potentialpunkt P angeschlossen. Der Kollektor des Transistors 25 ist weiter mit einem andererseits an Masse angeschlossenen Widerstand 28 und mit der Basis eines Transistors 29 verbunden, dessen Emitter an Masse liegt und dessen Kollektor über einen Widerstand 30 an die Ausgangsklemme 1 angeschlossen ist.

An den Emitter des Transistors 17 ist auch ein Widerstand 33 angeschlossen, dessen anderes Ende mit dem Kollektor eines Transistors 32 verbunden ist, dessen Emitter an Erde liegt. Die Basis des Transistors 32 ist über einen Widerstand 31 an den Punkt P angeschlossen. Am Potentialpunkt P liegt auch der Kollektor eines Transistors 34, dessen Emitter an Masse angeschlossen ist und dessen Basis einerseits über einen Widerstand 35 an den Potentialpunkt Q und andererseits an den Kollektor eines Transistors 36 angeschlossen ist, dessen Emitter ebenso wie der Emitter eines Transistors 40 an Masse liegt. Die Basen der Transistoren 36 und 40 sind über Widerstände 38 bzw. 39 mit einem Potentialpunkt M verbunden, der über einen Widerstand 37 an den Potentialpunkt Q und über einen Widerstand 42 an eine Klemme 43 angeschlossen ist, an der über einen Koppelkondensator 44 die andererseits geerdete Quelle eines Synchronsignals 45, die auch ein Teil desselben Halbleiterkörpers wie der beschriebene Oszillator sein kann, angeschlossen werden kann. Der Kollektor des Transistors 40 ist über einen Widerstand 41 mit dem Verbindungspunkt der Widerstände 18 und 19 verbunden.

Im Betrieb ist an der Klemme 1 eine sägezahnförmige Spannung $v_c$ verfügbar. Dazu wird der Kondensator C durch einen über den Widerstand R zufliessenden Strom aufgeladen, wobei die Spannung $v_c$ etwa linear ansteigt; dies gilt jedenfalls dann, wenn der Strom durch den Widerstand R als nahezu konstant angenommen werden kann und wenn der Widerstandswert relativ hoch ist, so dass der Spannungsabfall am Widerstand R gross ist gegenüber der Spannungsänderung der Spannung $v_c$ am Kondensator C.

Solange die Spannung $v_c$ niedriger ist als die Spannung $V_1$, sind die Transistoren 4 und 5 gesperrt und der Transistor 6 ist leitend. Wie noch dargetan wird, sind dabei die Transistoren 32 und 40 gesperrt, der Transistor 16 wirkt als Emitterfolger derart, dass an seinem Emitter die Spannung $V_1 - v_{be}$ auftritt und über die einen kleinen Spannungsabfall verursachenden Widerstände 18 und 19 auf die Basis des Transistors 6 übertragen wird, wobei $v_{be}$ die nahezu konstante Schwellenspannung einer leitenden Basisemitterdiode, in diesem Fall der des Transistors 16, ist. Der Emitter des Transistors 16 liefert somit den Basisstrom für den Transistor 6, der erforderlich ist, um den vom Stromquellentransistor 7 gelieferten Emitterstrom durch den Transistor 6 zu führen. Dann sind auch die Transistoren 20, 21 leitend, so dass ein Strom nach dem Transistor 24 fliesst derart, dass auch dieser Transistor leitend gesteuert wird, und zwar derart, dass seine Kollektoremitterspannung nur zwei Zehntel Volt beträgt und damit kleiner ist als die Öffnungsspannung $v_{be}$ des Transistors 25, so dass dieser gesperrt ist.

Da der Transistor 5 nicht leitend ist, führen auch die Transistoren 22 und 23 keinen Strom. Durch den Widerstand 27 fliesst kein Strom, so dass die Transistoren 29 und 32 gesperrt sind. Solange über die Klemme 43 kein Signal zugeführt wird, ist das Potential am Punkt M niedrig und die Transistoren 34, 36 und 40 sind gesperrt. Der Transistor 17, dessen Emitterspannung höher ist als die Basisspannung, ist gesperrt.

Zu einem Zeitpunkt, der gegenüber dem Anfangszeitpunkt des Aufladeprozesses durch den dem Kondensator C über den Widerstand R zufliessenden Ladestrom bzw. durch die Zeitkonstante des durch die Elemente R und C gebildeten Netzwerkes bestimmt ist, erreicht die Spannung $v_c$ den Wert $V_1$. Das bedeutet, dass die Spannung an der Basis des Transistors 5 gleich $V_1 - v_{be}$ ist und daher gleich der Spannung an der Basis des Transistors 6. Unter diesen Umständen fangen die Transistoren 4 und 5 zu leiten an mit der Folge, dass auch die Transistoren 22 und 23 leitend sind und über die Widerstände 26, 27 und 28 Strom zugeleitet wird. Dann nimmt das Potential an den Punkten Q, P und M derart zu, dass die Transistoren 32, 36 und 40 leitend werden. Der Kollektorstrom des Transistors 36, der über den Widerstand 35 vom Punkt Q aufgenommen wird, ist viel grösser als der Strom, der zur Basis des Transistors 34 fliessen würde, wenn dieser Transistor zu dem genannten Zeitpunkt in den leitenden Zustand geraten wäre, so dass der Transistor 34 weiter gesperrt bleibt und das Leitendwerden des Transistors 32 nicht vermeidet.

Da die Transistoren 5 und 6 eine Differenzverstärkerschaltung bilden und die Summe ihrer Emitterströme durch den Stromquellentransistor 7 konstant gehalten wird, nimmt der Emitterstrom des Transistors 6 ab, wenn der Transistor 5 leitend wird. Die Kollektorströme der Transistoren 20, 21 und 24 nehmen ab, wodurch der Transistor 25 leitend wird und den Transistor 29 gesperrt hält. Infolge des leitend gewordenen Transistors 32 fliesst durch den Widerstand 33 ein Strom und zwar derart, dass die Spannung an der Basis des Transistors 6 abnimmt. Die Widerstände 18, 19 und 33 sind derart gewählt worden, dass diese Spannung bei leitendem Zustand des Transistors 32 den Wert $V_2 - v_{be}$ unterschreiten würde. Weil der Transistor 17 dann in den leitenden Zustand gerät, kann jedoch die genannte Spannung nicht weiter sinken. Die weitere Abnahme des Emitterstromes des Transistors 6 geht einher mit einer weiteren Zunahme des Emitterstromes des Transistors 5; es ergibt sich somit ein selbstverstärkender Effekt, der zu einem sehr schnellen Sperren des Transistors 6 und damit auch der Transistoren 20, 21, 24 und 25 führt. Durch einen vom Punkt P über den Widerstand 27 zufliessenden Strom wird dann der Transistor 29 leitend, so dass über den Widerstand 30 ein Entladestrom vom Kondensator C fliesst. Die Spannung $v_c$ nimmt somit etwa linear ab mit einer Zeitkonstante, die von den Werten der Elemente R, C und 30 abhängig ist. Dabei ist Bedingung, dass der durch den Widerstand R fliessende Ladestrom kleiner ist als der Kollektorstrom des Transistors 29. Schliesslich wird der Transistor 40 durch einen über die Widerstände 37 und 39 zugeführten Basisstrom soweit leitend, dass sein über den Widerstand 41 fliessender Kollektorstrom eine weitere Verringerung der Spannung am Verbindungspunkt der Widerstände 18 und 19 verursacht. Weil die Spannung an der Basis des Transistors 6 durch den als Emitterfolger wirkenden Transistor 17 auf den Wert $V_2 - v_{be}$ geklemmt wird, hat der leitende Zustand des Transistors 40 darauf keinen Einfluss.

Die beschriebene Situation der Schaltungsanordnung nach Fig. 1 wird während des Entladens des Kondensators C beibehalten. Ein in diesem Zeitintervall auftretender positiv gerichteter Synchronimpuls an der Klemme 43 hätte keinen Einfluss, weil er lediglich das bereits positive Potential am Punkt M etwas erhöhen würde, wodurch sich jedoch am Schaltzustand der angeschlossenen Transistoren nichts ändert.

Zu dem Zeitpunkt, da die Spannung $v_c$ durch Entladung des Kondensators C den niedrigeren Wert $V_2$ angenommen hat, werden die Spannungen an den Basiselektroden der Transistoren 5 und 6 gleich. Der Transistor 6 und daher auch die Transistoren 20, 21 und 25 fangen zu leiten an, während der Emitterstrom des Transistors 5 abnimmt. Wenn der Transistor 25 leitend ist derart, dass seine Kollektoremitterspannung kleiner ist als die Spannung $v_{be}$, gerät der Transistor 29 in den gesperrten Zustand, wodurch das Entladen des Kondensators C aufhört und die Spannung $v_c$ wieder ansteigt. Dadurch, dass der Transistor 5 weniger leitend ist, sind auch die Transistoren 22 und 23 weniger leitend, so dass die Spannungen am Punkt Q und am Punkt P abnehmen, was eine Verringerung des Kollektorstromes des Transistors 32 und daher ein Ansteigen der Spannung an der Basis des Transistors 6 verursacht mit der Folge, dass der Emitterstrom des Transistors 6 noch weiter zunimmt. Dieser Effekt ist folglich selbstverstärkend und verursacht ein sehr schnelles Sperren der Transistoren 4, 5, 22, 23, 25 und 32. Wegen des Anstieges der Spannung an der Basis des Transistors 6 wird auch der Transistor 17 gesperrt, wodurch die Basisspannung am Transistor 6 wieder etwa den Wert $V_1 - v_{be}$ annimmt. Auch die Transistoren 36 und 40 kommen von der Spannung am Punkt Q her wieder in den gesperrten Zustand.

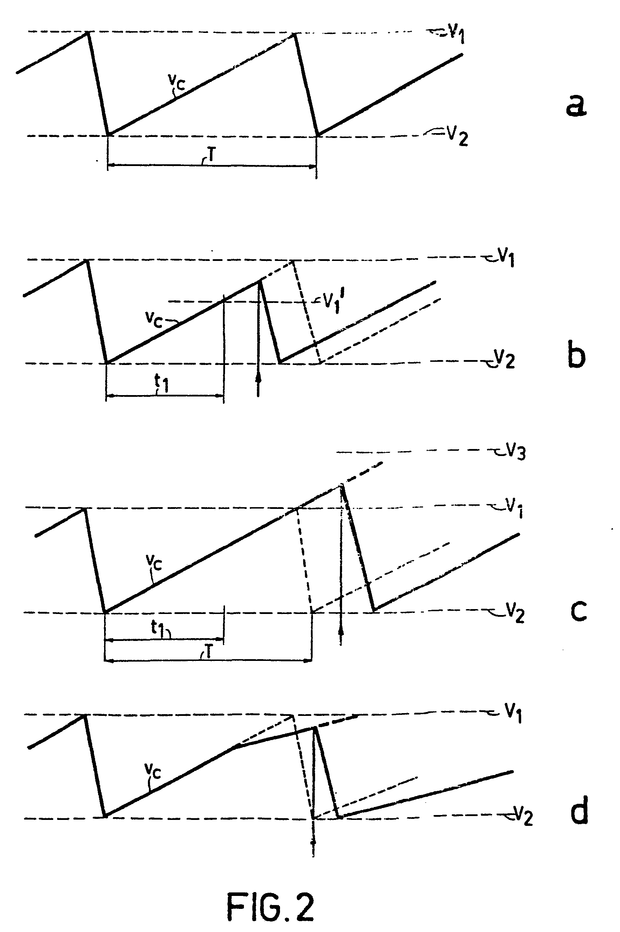

Aus dem obenstehenden geht hervor, dass die Schaltungsanordnung aus Fig. 1 sich beim Fehlen eines Synchronsignals als freilaufender Sägezahnoszillator verhält, der eine sägezahnförmige Spannung $v_c$ an der Klemme 1 erzeugt. Diese Spannung, die in Fig. 2a als Funktion der Zeit aufgetragen ist, variiert zwischen nahezu zwei konstanten Werten $V_1$ und $V_2$. Die Periode T der freien Schwingung und daher die Freilauffrequenz $f = 1/T$ wird durch die Werte der Spannungen $V_1$ und $V_2$ bestimmt sowie durch die der oben erwähnten Zeitkonstanten bzw. durch die Grösse des Kondensators sowie den Lade- und den Entladestrom. Als Freilauffrequenz (Eigenfrequenz) wird die Nennfrequenz der Synchronimpulse gewählt, was die eingangs erwähnten Vorteile bietet. Ist z.B. der Oszillator aus Fig. 1 der Vertikaloszillator in einem Fernsehempfänger, dann ist $f = 50$ Hz (europäische Norm) gewählt. Für den Horizontaloszillator kann dieselbe Schaltungsanordnung gewählt werden, wobei die Elemente für $f = 15.625$ Hz (europäische Norm) bemessen sind. In der Praxis können die beiden Schaltungsanordnungen identisch oder nahezu identisch ausgebildet werden, mit Ausnahme jedoch der äusseren Elemente R und C.

Trotz der Tatsache, dass der Oszillator die Nennfrequenz hat, muss nachsynchronisiert werden können. Dies ist ja beim Anlaufen des Empfängers nach dem Einschalten desselben notwendig. Auch können Frequenzänderungen auftreten sowohl senderseitig, z.B. beim Umschalten des Empfängers auf einen anderen Sender, sowie empfängerseitig, z.B. infolge von Toleranzen, Alterung von Elementen und dergl. Ausserdem könnte der Oszillator, wenn seine Freilauffrequenz höher wird als die Nennfrequenz, z.B. weil der Aufladestrom des Kondensators C grösser und daher die ansteigende Flanke der Sägezahnform in Fig. 2a steiler geworden ist, nicht synchronisiert werden, da ein Synchronimpuls erst nach dem Umkippen der Sägezahnform auftreten würde und daher keinen Einfluss mehr ausüben könnte.

Wenn an der Klemme 43 ein Synchronsignal vorhanden ist, wird durch dieses die Spannung am Punkt M bestimmt. Das Synchronsignal kann üblicherweise aus einer Reihe von Impulsen bestehen, die kurzzeitig einen positiven Wert von einigen Volt annehmen. Über den Koppelkondensator 44 wird die Gleichstromkomponente nicht übertragen.

Wenn die positiven Impulse auftreten, werden die Transistoren 36 und 40 leitend. Dadurch werden die Scheitel der zugeführten Synchronimpulse auf einen Wert geklemmt, der etwas oberhalb der Öffnungsspannung $+v_{be}$ liegt. Zwischen den Impulsen ist dann die Spannung am Punkt 43 um die Amplitudenhöhe der Impulse niedriger und vorzugsweise negativ. Die Amplitude der Synchronimpulse sowie die Werte der Widerstände 38, 39 und 42 werden derart gewählt, dass der Zustand der Transistoren 34, 36 und 40 durch den niedrigeren Wert der Spannung am Punkt M nicht und durch den höheren Wert derselben wohl beeinflusst wird. Während der ansteigenden Flanke der Sägezahnform aus Fig. 2a sind die genannten Transistoren zunächst nach wie vor gesperrt.

Tritt ein Synchronimpuls auf, während die Spannung $v_c$ den Wert $V_1$ noch nicht erreicht hat, nimmt die Spannung am Punkt M ihren höheren Wert an, durch den der Transistor 40 in den leitenden Zustand gebracht wird. Weil die Spannungen an den Punkten P und Q Null sind, führen die Transistoren 34 und 36 keinen Kollektorstrom. Infolge des durch die Widerstände 41 und 18 fliessenden Kollektorstromes des Transistors 40 wird der Spannungsabfall am Widerstand 18 höher, so dass die Spannung am Verbindungspunkt der Widerstände 18 und 19 binnen kurzer Zeit verringert wird, und zwar bis auf einen Wert $V'_1$, der durch das Verhältnis der Werte der Widerstände 18 und 41 bestimmt wird und der zwischen $V_1 - v_{be}$ und $V_2 - v_{be}$ liegt. Ist dieser Wert niedriger als oder gleich dem Wert, den die Spannung $v_c$ zu demselben Zeitpunkt hat, verringert um $v_{be}$, so werden die Transistoren 4 und 5, die bislang gesperrt waren, leitend, wodurch die abfallende Flanke der Sägezahnform sehr schnell eingeleitet wird. Ist dagegen die Spannung $V'_1$ höher als der ausgenblickliche Wert von $v_c - v_{be}$, so hat der Synchronimpuls keinen Einfluss, und die Spannung $v_c$ steigt nach wie vor an. Der Wert $V'_1$ bestimmt folglich das Zeitintervall $t_1$ nach dem Anfangszeitpunkt der ansteigenden Flanke, von dem ab der Oszillator aus Fig. 1 von einem Synchronimpuls synchronisiert werden kann. In Fig. 2b wird der Fall dargestellt, dass der durch einen Pfeil angegebene Impuls nach dem Intervall $t_1$, jedoch bevor die Spannung $v_c$ den Wert $V_1$ erreicht hat, auftritt. In diesem Fall ist die Wiederholungsfrequenz der Synchronimpulse höher als die eigene Freilauffrequenz des Oszillators, d.h. die Periode der Synchronimpulse ist kürzer als die Periode des freilaufenden Oszillators.

Wenn ein Synchronsignal auftritt, nimmt zwischen den Synchronimpulsen der Punkt M ein niedriges Potential an. Ist nach dem Intervall $t_1$ noch kein Impuls aufgetreten bis zu dem Zeitpunkt, an dem die Spannung $v_c$ den Wert $V_1$ erreicht, so werden, wie bereits erwähnt, die Transistoren 4, 5, 22, 23 und 25 leitend. Die Spannung am Punkt M hat infolge der Steuerung von der Klemme 43 noch immer einen niedrigen Wert, so dass die Transistoren 36 und 40, die beim Fehlen des Synchronsignals durch einen durch den Widerstand 37 fliessenden Strom in den leitenden Zustand gebracht und in diesem Zustand gehalten würden, nun gesperrt bleiben. Durch den Widerstand 35 fliesst jedoch von dem höheren Potentialwert des Punktes Q ein Strom zur Basis des Transistors 34, so dass dieser leitend wird. Der Widerstand 26 liegt als Kollektorwiderstand des Transistors 34 an der positiven Spannung am Punkt Q, so dass sich am Widerstand 26 ein Spannungsabfall ergibt derart, dass die Spannung am Punkt P nahezu Null wird. Die Transistoren 25, 29 und 32 bleiben daher gesperrt mit der Folge einerseits, dass die Spannung $v_c$ über den Wert $V_1$ hinaus steigt und andererseits, dass die Spannung an der Basis des Transistors 6 weiterhin den Wert $V_1$-$v_{be}$ beibehält.

Zu dem Zeitpunkt, da ein Synchronimpuls auftritt, steigt die Spannung am Punkt M über den Ansprechwert, d.h. etwa $v_{be}$ der Transistoren 36 und 40, die dann zu leiten anfangen. Die Kollektoremitterspannung des Transistors 36 wird nahezu Null, wodurch der Transistor 34 gesperrt wird. Die Spannung am Punkt P wird positiv, und die Transistoren 29 und 32 werden auch leitend, was das Entladen des Kondensators C einleitet, während die Spannung an der Basis des Transistors 6 den Wert $V_2$-$v_{be}$ annimmt. Es sei bemerkt, dass die Spannung an dem Verbindungspunkt der Widerstände 18 und 19 vorübergehend den Wert $V'_1$ annimmt, doch dies ist nicht von Bedeutung, da die Spannung an der Basis des Transistors 6 den Wert $V_2$-$v_{be}$ nach wie vor beibehält während der ganzen Entladung des Kondensators C.

Der vorstehend beschriebene Fall ist in Fig. 2c dargestellt; dabei ist die Frequenz der Synchronimpulse niedriger als die Freilauffrequenz des Oszillators, d.h., ihre Periode ist grösser als die des Oszillators. Dasselbe kann auch auftreten, wenn nur ein Synchronimpuls innerhalb des Zeitintervalls $t_1$ und einer, nachdem die Spannung $v_c$ den Wert $V_1$ angenommen hat, aufgetreten ist, während die Frequenz der Impulse nicht niedriger ist als die Eigenfrequenz des Oszillators.

Tritt kein Synchronimpuls auf, nachdem die Spannung $v_c$ den Wert $V_1$ überschritten hat, so steigt die Spannung $v_c$ nach wie vor. Dies ist in Fig. 2c gestrichelt dargestellt. Der Endwert der Spannung $v_c$ wäre die Spannung $V_B$, und das freie Umkippen des Oszillators würde nicht erfolgen. Dies kann für viele Anwendungsbereiche, z.B. in der Fernsehtechnik, wobei die Ablenkung aufhören würde, unerwünscht sein. Um dies zu vermeiden, ist, wie in Fig. 1 angegeben, ein Kondensator 44 vorgesehen zwischen der Quelle 45 des Synchronsignals und der Klemme 43. Über den Kondensator wird kein Dauergleichstrom übertragen. An der Klemme 43 ist eine Gleichspannung vorhanden, die dem mittleren Wert des impulsförmigen Signals entspricht und daher beim Fehlen dieses Signals Null ist. Diese Gleichspannung ist zu niedrig um die Transistoren 36 und 40 in den leitenden Zustand zu bringen. Zu dem Zeitpunkt, wo die Spannung $v_c$ den Wert $V_1$ erreicht, fängt der Transistor 23 zu leiten an und fliesst über die Widerstände 37 und 42 ein Ladestrom zum Kondensator 44. Dadurch steigt die Spannung an der Klemme 43 und zwar bis der Transistor 36 in den leitenden Zustand gerät, was das Umkippen des Oszillators verursacht. Die Wahl der Zeitkonstante des von den Widerständen 37 und 42 und dem Kondensator 44 gebildeten Netzwerkes bestimmt den Zeitpunkt und daher den Schwellenwert über $V_1$, an dem dieses Umkippen erfolgt, wonach der Kondensator sich über die Widerstände 38 und 39 entlädt bis zum mittleren Wert des Synchronsignals.

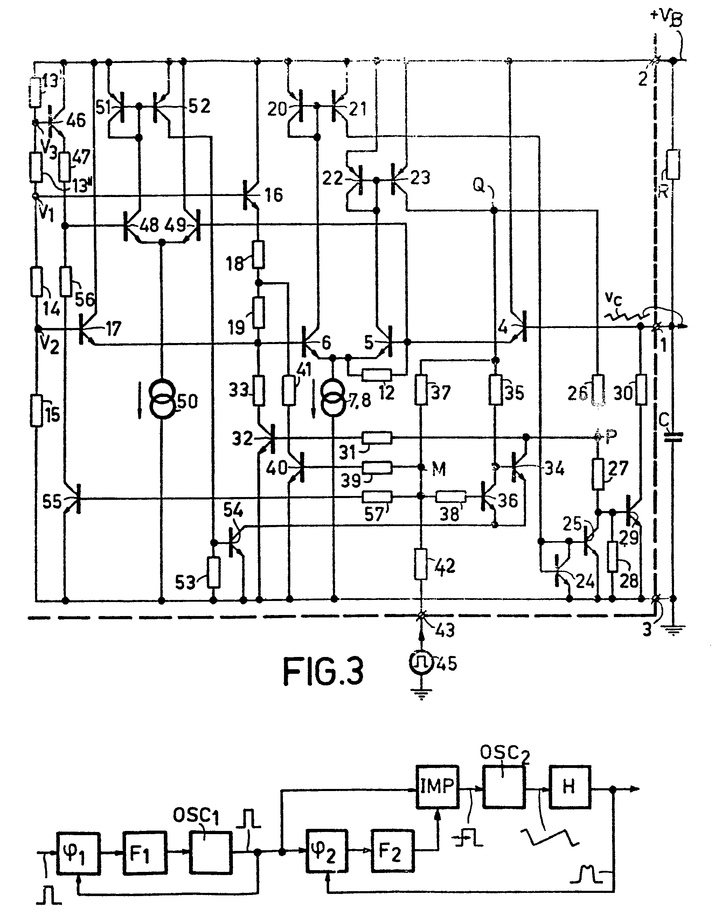

Mit der Schaltungsanordnung nach Fig. 3 ist eine Kopplung der Quelle 45 über einen auf die vorstehend erläuterte Weise bemessenen Kondensator 44 nicht erforderlich. Gegenüber Fig. 1 ist ein grosser Teil der Schaltungsanordnung in Fig. 3 nicht geändert, und dieselben Elemente tragen entsprechende Bezugszeichen.

In Fig. 3 ist gegenüber Fig. 1 der Widerstand 13 durch die Reihenschaltung aus zwei Widerständen 13' und 13" ersetzt worden, an deren Verbindungspunkt im Betrieb eine Spannung $V_3$ vorhanden ist, die höher ist als die Spannung $V_1$, die am Verbindungspunkt der Widerstände 13" und 14 vorhanden ist. Der erstgenannte Verbindungspunkt ist mit der Basis eines Transistors 46 verbunden, dessen Kollektor an der Spannung $V_B$ liegt und dessen Emitter über einen Widerstand 47 mit der Basis eines Transistors 48 verbunden ist. Mit einem weiteren Transistor 49 bildet der Transistor 48 eine Vergleichsstufe. Dazu sind die Emitter miteinander und mit einer Stromquelle 50 verbunden. Der Kollektor des Transistors 49 liegt an der Spannung $V_B$, während der des Transistors 48 mit den Basen zweier npn-Transistoren 51 und 52 verbunden sind, deren Emitter an der Spannung $V_B$ liegen. Der Kollektor des Transistors 51 ist mit der Basis desselben und der des Transistors 52 ist mit einem Widerstand 53 und der Basis eines Transistors 54 verbunden. Der andere Anschluss des Widerstandes 53 und der Emitter des Transistors 54 liegen an Masse, während der Kollektor desselben mit den Emittern der Transistoren 34 und 35, die nicht an Masse liegen, wie in Fig. 1 der Fall ist, verbunden ist. Zum Schluss enthält der Oszillator aus Fig. 3 einen Transistor 55, dessen Emitter an Masse liegt, während der Kollektor über einen Widerstand 56 mit der Basis des Transistors 48 und die Basis über einen Widerstand 57 mit dem Punkt M verbunden ist.

Solange die Spannung $v_c$ niedriger ist als die Spannung $V_1$, ist der Transistor 48 leitend, während die Transistoren 49 und 55 gesperrt sind, so dass auch die Transistoren 51, 52 und 54 leitend sind. Die Emitter der Transistoren 34 und 36 haben nahezu Massepotential. Dies ist der bereits beschriebene Zustand, in dem die Spannung $v_c$ nach wie vor ansteigt. Beim Fehlen des Synchronsignal wird zu dem Zeitpunkt, wo die Spannung $v_c$ den Pegel $V_1$ erreicht, der Transistor 55 durch einen über die Widerstände 37 und 57 fliessenden Strom leitend, wodurch die Spannung an der Basis des Transistors 48, die nahezu den Wert $V_3$-$v_{be}$ hatte, verringert wird. Die Werte der Widerstände 47 und 56 sind derart gewählt worden, dass der neue Wert der genannten Spannung niedriger ist als der Wert $V_1$-$v_{be}$, so dass die Transistoren 48, 51, 52 und 54 auf die bereits beschriebene selbstverstärkende Art und Weise aus dem leitenden Zustand geraten, mit der Folge, dass die Emitter der Transistoren 34 und 36 nicht mehr an Masse liegen und dass diese Transistoren ebenfalls gesperrt werden. Die Spannung am Punkt P wird positiv, was das Leitendwerden der Transistoren 29 und 32 verursacht und daher das Entladen des Kondensators C zur Spannung $V_2$ einleitet und dies auf dieselbe Art und Weise wie in Fig. 1 der Fall ist.

Gibt es an der Klemme 43 ein Synchronsignal, so verursacht ein Impuls, der nach einem auf dieselbe Art und Weise wie $t_1$ in Fig. 2b bestimmten Intervall und bevor die Spannung $v_c$ dem Wert $V_1$ entspricht, auftritt, das Umkippen des Oszillators auf dieselbe Art und Weise wie die obenstehend beschriebene. Ist der Impuls noch nicht zu dem Zeitpunkt, an dem die Spannung $v_c$ dem Wert $V_1$ gleich wird, aufgetreten, so bleiben die Transistoren 36 und 55 gesperrt, weil die Spannung am Punkt M niedrig ist, während der Transistor 34 wegen eines durch den Widerstand 35 fliessenden Basisstromes leitend wird. Die Spannung am Punkt P ist Null, was die Transistoren 29 und 32 gesperrt hält. Die Spannung $v_c$ nach wie vor, bis ein Synchronimpuls auftritt oder bis der Wert $V_3$ erreicht wird. In diesem letzteren Fall werden die Spannungen an den Basen der Transistoren 48 und 49 einander gleich, wodurch der Transistor 49 zu leiten anfängt, was zu dem Umkippen des Oszillators führt.

Weil die Abwandlung der Fig. 3 keinen Koppelkondensator zwischen der Quelle 45 und der Klemme 43 braucht, kann die Klemme 43 völlig fortfallen in dem Fall, dass auch die Quelle 45, z.B. ein Amplitudensieb, einen Teil des Halbleiterkörpers bildet, in dem der beschriebene Sägezahnoszillator integriert ist.

In Fig. 1 hat der Transistor 36 zur Aufgabe, das Leiten des Transistors 34, der das Nichtumkippen des Oszillators bei $v_c = V_1$ verursachen würde, zu vermeiden, und dies beim Fehlen des Synchronsignals oder beim Vorhandensein desselben, wenn ein Synchronimpuls bei $v_c = V_1$ noch nicht aufgetreten ist. In Fig. 3 haben die Transistoren 36 und 54 die genannte Aufgabe. Der Transistor 36 bzw. die Transistoren 36 und 54 bilden also einen Synchronimpulsdetektor zum Detektieren des Vorhandenseins des Synchronsignals und sie sorgen ebenfalls dafür, dass der Pegel $V_1$ nötigenfalls überschritten werden kann. Wenn kein Synchronsignal an der Klemme 43 vorhanden ist, wird der Kondensator C aufgeladen und die Spannung $v_c$ steigt entsprechend Fig. 2a zum Wert $V_1$. Bleibt das Signal zu dem Zeitpunkt, an dem die Spannung $v_c$ den genannten Wert $V_1$ erreicht, noch immer weg, so kippt der Oszillator um. Ist dagegen vorher ein Synchronsignal angelangt und tritt ein Impuls auf, so kippt der Oszillator nach Fig. 2b um. Im Nennzustand des Oszillators sowie der Synchronimpulse, in dem die Eigenfrequenz des Oszillators und die Wiederholungsfrequenz der Impulse gleich einander sind, wird das nachfolgende Umkippen des Oszillators entsprechend Fig. 2a, d.h. nach einer Zeit T erfolgen. In der Praxis wird von diesem Zustand abgewichen, so dass das nachfolgende Umkippen erfolgt, entweder wieder entsprechend Fig. 2b, oder entsprechend Fig. 2c, in welchem Fall der Wert $V_1$ von der Spannung $v_c$ überschritten wird.

Bei der Ausführungsform nach Fig. 1 wird die längste Eigenperiode dadurch begrenzt, dass bei Auftreten eines Synchronsignals zwischen den Impulsen eine niedrigere Spannung am Punkt M wirksam wird. Wenn das Synchronsignal wegfällt, wird diese Spannung, da durch den Kondensator 44 eine Gleichstromtrennung bewirkt wird, nach einer durch die Zeitkonstante des Kondensatornetzwerkes bedingten Zeit abgebaut, so dass sich dann wieder die etwa dem Nennwert entsprechende Eigenfrequenz einstellt.

Bei der Ausführungsform nach Fig. 3 wird ein weiterer Schwellwert $V_3$ oberhalb der die Freilauffrequenz bedingenden Spannung $V_1$ eingeführt, der auch dann wirksam ist, wenn die Schwellenspannung $V_1$ durch die Wirkung des Synchrondetektors unwirksam gemacht ist. Genauer gesagt, wird im zweiten Zustand mittels des leitend gesteuerten Transistors 34 verhindert, dass der Rücklauf beginnt, wenn die Spannung $v_c$ den Wert $V_1$ überschreitet. Durch eine dritte Schwellwertschaltung mit den Transistoren 48 und 49 wird jedoch der Stromkreis des Transistors 34 mittels des Transistors 54 unterbrochen, wenn die Spannung $v_c$ den höheren Wert $V_3$ überschreitet. Dann ist also die Blockierung behoben und der Rücklauf setzt ein.

Obenstehend ist gleichsam eine der Schwellenspannungen auf einen anderen Wert verlegt in dem Fall, dass ein Synchronimpuls von einem bestimmten Zeitpunkt ab erwartet werden konnte, jedoch nicht aufgetreten ist zu dem Zeitpunkt, an dem $v_c = V_1$ ist. Dadurch wird die Amplitude der Sägezahnform vergrössert und folglich die Eigenfrequenz des Oszillators verringert. Diese Verringerung kann auf die Art und Weise, die in Fig. 2d dargestellt ist, erhalten werden. Dabei bleibt die genannte Amplitude, d.h. die Differenz zwischen den Spannungen $V_1$ und $V_2$, unter allen Umständen nahezu konstant, während eine der Neigungen, vorzugsweise diejeniger der ansteigenden Flanke der Sägezahnform eine Änderung erfahren kann. Wenn zu dem Anfangszeitpunkt einer Aufladezeit kein Synchronsignal vorhanden ist, wird der Kondensator C von einem Strom mit einem bestimmten Wert aufgeladen. Wird beim Aufladen das Vorhandensein eines Synchronsignals, z.B. auf die anlässlich Fig. 1 und 3 beschriebene Weise detektiert, so erhält der Ladestrom zu demselben Zeitpunkt einen niedrigeren Wert, wodurch die ansteigende Flanke der Sägezahnform weniger steil wird. Dies entspricht einer niedrigeren Eigenfrequenz des Oszillators. Beim Auftritt des Synchronimpulses kippt der Oszillator auf die bereits beschriebene Art und Weise um, wonach eine neue Aufladezeit anfängt, wobei der Aufladestrom seinen niedrigeren Wert hat, wenn das Synchronsignal noch immer vorhanden ist.

Obenstehendes kann dadurch durchgeführt werden, dass der Widerstand R durch z.B. die Reihenschaltung aus zwei Widerständen ersetzt wird, von denen der eine durch einen Transistor in dem Zustand, wo es kein Synchronsignal gibt, kurzgeschlossen werden kann. Auch kann der Widerstand R durch eine richtige mit Transistoren und Widerständen aufgebaute Stromquelle ersetzt werden, die zwei Werte annehmen kann. Es dürfte einleuchten, dass in dem Fall der Fig. 2d die Aufladeanordnung des Kondensators C vorzugsweise in den Halbleiterkörper aufgenommen werden wird. Es sei bemerkt, dass mit der weiterhin nicht detailliert beschriebenen Ausbildung nach Fig. 2d eine Sägzahnform entsteht, die mindestens einmal einen Knick aufweist. Dies braucht jedoch kein Nachteil zu sein; bei manchen Anwendungsbereichen kann nämlich eine derartige Verformung zulässig sein. Ein Beispiel davon ist die Vertikalablenkung in Fernsehempfängern, wobei der eigentliche Vertikaloszillator, dessen Signal eine konstante Amplitude hat und von einem Leistungsverstärker verstärkt wird, bevor es einer Ablenkspule abgegeben wird, das Signal zugeführt bekommt, das von einem durch Synchronimpulse synchronisierbaren Sägezahngenerator herrührt, welcher Generator der der Erfindung sein kann.

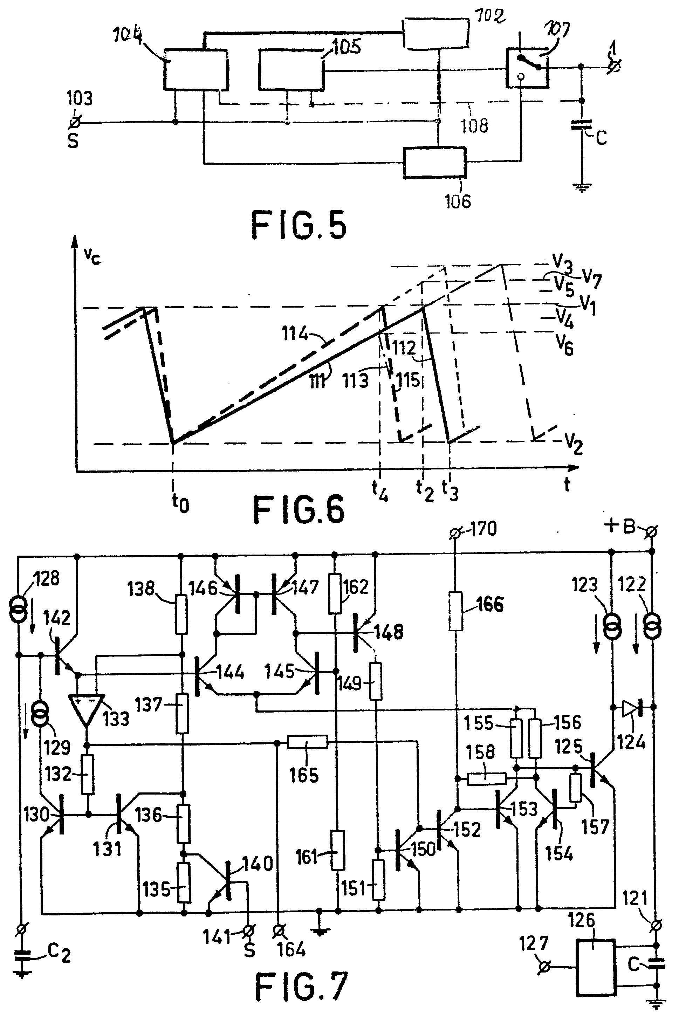

Fig. 4 zeigt in grossen Zügen eine andere Anwendungsmöglichkeit der erfindungsgemässen Schaltungsanordnung.

Die Figur bezieht sich auf eine Schaltungsanordnung zur indirekten Horizontalsynchronisierung in einem Fernsehempfänger, in dem empfangene Horizontalsynchronimpulse und Impulse, die von einem Horizontaloszillator $OSC_1$ erzeugt sind, in einem Phasendiskriminator $\varphi_1$ verglichen werden. Der Diskriminator $\varphi_1$ verwandelt einen ermittelten Phasenunterschied in eine Regelspannung, die nach Glättung durch ein Tiefpassfilter $F_1$ dem Oszillator $OSC_1$ zugeführt wird. Die Impulse desselben, die nahezu die richtige Frequenz und die richtige Phase gegenüber den horizontalsynchronimpulsen aufweisen, werden einem zweiten Phasendiskriminator $\varphi_2$ zugeführt, in dem sie mit von der Horizontalendstufe H herrührenden Impulsen verglichen werden. Die Ausgangsspannung des Diskriminators $\varphi_2$ erreicht nach Glättung durch ein zweites Tiefpassfilter $F_2$ einen Impulsformer IMP, der die Impulse vom $OSC_1$ zugeführt bekommt. Die Impulse des Impulsformers IMP synchronisieren einen Sägezahnoszillator $OSC_2$, der nach Fig. 1 oder Fig. 3 ausgebildet ist und die dadurch erzeugte Sägezahnspannung wird der Stufe H zugeführt, in der sie in ein Schaltsignal umgewandelt wird, das einem Horizontalausgangstransformator zugeführt wird. An diesen Transformator ist eine nicht dargestellte Ablenkspule für die Horizontalablenkung angeschlossen.

Das Prinzip einer derartigen doppelten Schleigfe zur indirekten Horizontalsynchronisation und die Wirkungsweise derselben sind in der DE-PS Nr. 2211100 eingehend beschrieben worden. In der genannten PS beeinflusst die Ausgangsspannung des zweiten Phasendiskriminators den zweiten Oszillator direkt, während ein Impulsformer, dem Signale des ersten Oszillators zugeführt sein würden, völlig fehlt. Durch die Wirkung der zweiten Schleife wird dafür gesort, dass der Einfluss von Änderungen der Belastung auf die Stufe H zum grossen Teil aufgehoben wird. Während der erste Oszillator abhängig von der Frequenz und von der Phase der Synchronimpulse geregelt wird, wird der zweite Oszillator abhängig von der Phase der horizontalfrequenten Impulse, die in der Stufe H entstehen, geregelt. Die zweite Schleife introduiziert von sich aus einem kleinen Phasenfehler, der der Tatsache zuzuschreiben ist, dass ihre Verstärkung nicht unendllich ist.

Wird nun die zweite Synchronisationsschleife ausgebildet, wie in Fig. 4 angegeben ist, so wird dieser Fehler verringert, ohne dass die Schleifenverstärkung erhöht zu werden braucht, was ja zu Unstabilität führen könnte. Dazu erzeugt der Impulsformer IMP Impulse, die dieselbe Frequenz aufweisen, wie die vom Oszillator $OSC_1$ erzeugten Impulse, wobei die Phasenlage nur einer Flanke, z.B. der Vorderflanke, jedes Impulses der Stufe IMP durch die vom Filter $F_2$ herrührende Regelspannung geregelt wird. Diese Flanke synchronisiert daraufhin den Oszillator $OSC_2$. Auf diese Weise wird gewährleistet, dass die vom Oszillator $OSC_2$ erzeugte Sägezahnform immer die richtige Frequenz hat, und zwar die des Oszillators $OSC_1$, und die von der zweiten Schleife bestimmte Phase. Der einzige Fehler, der dann noch übrigbleibt, wird durch die nicht unendliche Empfindlichkeit des Diskriminators $\varphi_2$ verursacht, während der Oszillator $OSC_2$, der ja nicht geregelt sondern durch eine Impulsflanke synchronisiert wird, keinen Phasenfehler einführt.

Fig. 5 zeigt eine Schaltungsanordnung zum Erzeugen einer Sägezahnspannung $v_c$ am mit der Ausgangsklemme 1 verbundenen Kondensator C, dem von einer Ladeschaltung 102 ein Ladestrom oder ein, vorzugsweise merklich grösserer, Entladestrom abwechselnd zugeführt wird. Dadurch entsteht am Kondensator C ein Spannungsverlauf nach der ausgezogenen Kurve 111, die in Fig. 6 die Kondensatorspannung $v_c$ über der Zeit t darstellt. Dabei beginnt der Hinlaufteil bei einem unteren Spannungswert $V_2$ in einem Zeitpunkt $t_0$ und steigt zeitproportional an.

Wenn in einem Zeitpunkt $t_2$ in der Schaltung nach Fig. 5 von einer Klemme 103 ein Synchronimpuls S mit der Nennfrequenz von z.B. 50 Hz der Ladeschaltung 102 zugeführt wird, wird z.B. ebenfalls von der Schaltung 102 dem Kondensator C ein Entladestrom zugeleitet, so dass bei einer Spannung $V_1$ der Rücklauf 112 beginnt. Dieser endet bei der Spannung $V_2$ in einem Zeitpunkt $t_3$, der dem Zeitpunkt $t_0$ entspricht und in dem ein neuer Hinlauf beginnt. Wenn dagegen die Frequenz der Synchronsignale einen zweiten höheren Wert von z.B. 60 Hz aufweist, würde ein Synchronimpuls — auf den gleichen Hinlaufanfang $t_0$ und gleiche Steilheit des Spannungsanstieges bezogen — in einem früheren Zeitpunkt $t_4$ eintreffen und den an der Kurve 111 in diesem Zeitpunkt strichpunktiert angedeuteten Rücklauf 113 zur Spannung $V_2$ einleiten. Der Sägezahn erreicht dabei eine Amplitude $V_6$, die gegenüber dem bei der ersten niedrigeren Frequenz erreichten Wert $V_1$ merklich niedriger ist.

Die Synchronimpulse S werden nach der Erfindung von der Klemme 103 auch einem (zweiten) Synchronsignaldetektor 105 zugeführt, und ausserdem ist eine zweite Ladeschaltung 106 vorgesehen, deren Ausgang ebenso wie der Ausgang der Ladeschaltung 102 an eine Umschaltstufe 107 angeschlossen ist. Diese enthält einen Umschalter, mit dem der Kondensator C und die Ausgangsklemme 1 entweder an die Ladeschaltung 102 oder an die Ladeschaltung 106 angeschlossen werden abhängig davon, ob durch den Synchronsignaldetektor 105 festgestellt wird, dass Synchronimpulse S des niedrigeren oder des höheren Frequenzwertes auftreten. Dadurch wird beim ersten niedrigeren Synchronsignal-Frequenzwert der niedrigere Lade- und ggf. Entladestrom der Stufe 102 dem Kondensator C zugeführt oder beim zweiten höheren Synchronsignal-Frequenzwert der höhere Lade- und ggf. Entladestrom von der Stufe 106 derart, dass bei beiden Frequenzen die Amplitude der Sägezahnspannung $v_c$ zwischen den Spannungswerten $V_2$ und $V_1$ verläuft und wenigstens annähernd gleich ist.

Die Schaltungsanordnung nach Fig. 5 kann einen anderen (ersten) Synchronsignaldetektor 104 enthalten, wobei die nachfolgende Ladestufe (102 bzw. 106) so ausgelegt ist, dass sie auch ohne Synchronisierung durch Impulse S periodisch etwa mit Nennfrequenz die Aufladung und Entladung des Kondensators C bewirkt. Durch die erwähnte Ausbildung des ersten Synchronsignaldetektors 104 wird das Vorhandensein bzw. das Fehlen des Synchronsignals S festgestellt, und beim Fehlen des Snychronsignals wird ein erster Schaltzustand der nachfolgenden Ladestufe (102 bzw. 106) hergestellt, in dem die Eigenfrequenz wenigstens annähernd der zugeordneten Nennwiederholungsfrequenz des Synchronsignals entspricht, während beim Vorhandensein des Synchronsignals der zweite Schaltzustand hergestellt wird, in dem die Eigenfrequenz der Schaltungsanordnung gegenüber dem erwähnten ersten Zustand niedriger ist. Ohne Synchronsignal schwingt die betreffende Schaltstufe dann etwa auf der vorgesehenen Nennfrequenz, während ihre Periode bei fehlenden Synchronsignalen grösser ist derart, dass eine direkte Synchronisierung möglich ist auch dann, wenn die von aussen zugeführten Synchronimpulse S gegenüber dem erwarteten Wert (Nennwert) eine etwas längere Periode aufweisen.

Wenn beim Empfang von 60 Hz-Synchronsignalen die Sägezahnerzeugungs-Schaltung, z.B. mittels der Stufe 107, so umgeschaltet ist, dass für den Kondensator C die Lade- bzw. Entladeschaltung 106 wirksam ist, verläuf die Sägezahnspannung $v_0$ vom Zeitpunkt $t_0$ ab gemäss der in Fig. 6 gestrichelt dargestellten Kurve 114, und die Rücklaufflanke 115 setzt infolge der Eigenfrequenz oder durch äussere Synchronisation im Zeitpunkt $t_4$ ein, so dass ein 60 Hz-Sägezahn entsteht. Wenn durch den (ersten) Synchronsignaldetektor 104 das Vorhandensein von Synchronimpulsen festgestellt ist, kann die Eigenfrequenz soweit verringert sein, dass der Rücklauf beim Erreichen einer Spannung $V_3$ einsetzen würde, wobei jedoch durch die Synchronimpulse S vorher die Rücklaufflanke 115 eingeleitet wird.

Bei einer Schaltungsanordnung nach Fig. 5 kann der Synchronsignaldetektor 105 und ggf. 104 von den Ladeschaltungen 102 und 106 getrennt sein und z.B. mit einem besonderen Sägezahnkondensator arbeiten. Es ist aber auch möglich, die am Kondensator C auftretende Sägezahnspannung $v_c$ entsprechend der in Fig. 5 gestrichelt eingetragenen Linie 108 an den Synchronsignal-Frequenzdetektor 105 und ggf. den Detektor 104 zurückzuführen und auszuwerten; dann ist z.B. bei einer integrierten Schaltung nur eine Klemme 1 für das Anschliessen eines aussen angeordneten Kondensators C erforderlich.

Dazu kann die Schaltung so ausgebildet sein, dass sie beim Einschalten des Gerätes und noch fehlenden Synchronimpulsen am Kondensator C eine Sägezahnspannung mit der niedrigeren Frequenz von 50 Hz in Selbststeuerung erzeugt. Wenn dann 50 Hz-Synchronimpulse S an der Eingangsklemme 103 auftreten, wird die Ladeschaltung 102 durch den ersten Synchronimpulsdetektor 104 in der beschriebenen Weise umgeschaltet derart, dass, wie der Kurve 111 in Fig. 6 zu entnehmen ist, die Periode der Eigenfrequenz bis zum Erreichen der Spannung $V_3$ verlängert wird und der Rücklauf 112 vorher durch den Synchronimpuls S ausgelöst wird. Dabei wird der erzeugte Sägezahn mittels einer Vergleichsschaltung gegenüber einer Spannung $V_4$ geprüft, die etwa in der Mitte liegt zwischen der Spannung $V_1$, die bei 50 Hz-Synchronimpulsen erreicht wird, und der Spannung $V_6$, bei der die Sägezahnflanke 111 durch den Rücklauf 113 vorzeitig beendet wird, wenn Synchronimpulse der anderen Frequenz von 60 Hz empfangen werden. Wenn diese Schwellenspannung, vorzugsweise mehrmals, z.B. 5- bis 20mal hintereinander, eine Synchronisierung vor Erreichen der Spannung $V_4$ festgestellt hat, wird, z.B. mittels des Schalters 107, der zweite Betriebszustand für die Synchronsignale höherer Frequenz von 60 Hz und damit der Übergang auf die Kurve 114, 115 in Fig. 6 hergestellt, in dem der Kondensator C einen entsprechend dem Frequenzverhältnis höheren Lade- und ggf. Entladestrom erhält.

Wenn in der zweiten Schaltlage für 60 Hz vom Benutzer auf einen anderen Sender mit 50-Hz-Ablenkung umgeschaltet wird, ergibt sich, dass der Synchronimpuls auf der Kurve 114 erst im Zeitpunkt $t_2$, also etwa bei einer Spannung $V_7$, den Rücklauf einleitet. In diesem zweiten Betriebszustand ist im zweiten Synchronsignaldetektor 105 eine Vergleichsschaltung wirksam, in der die Sägezahnspannung mit einer Bezugsspannung verglichen wird, die zwischen dem für den Rücklauf vorgesehene Wert $V_1$ und dem bei unrichtiger Synchronisierung erreichten Wert $V_7$ etwa in der Mitte bei einer Spannung $V_5$ liegt. Wird diese Spannung mehrmals, z.B. 5- bis 20mal hintereinander, überschritten, bedeutet das, dass ein 50-Hz-Signal empfangen wird. Dann wird, z.B. mittels der Umschaltstufe 107, wieder die Ladeschaltung 102 wirksam gemacht. Die Zahl der Überschreitungen kann mit einem Zähler festgestellt werden, der zurückgesetzt wird, wenn mehrmals keine Überschreitung erfolgt.

Wenn nach einem normalen Empfang die Synchronimpulse wegfallen, z.B. beim Umschalten auf einen anderen Sender, bleibt die Schaltung, insbesondere der Umschalter 107, zweckmässig in der bisherigen Lage, bis ein neuer Sender empfangen wird. Da ohne Synchronsignale ohnehin kein brauchbares Bild wiedergegeben werden kann, kann es auch zweckmässig sein, in diesem Zustand stets wieder auf die niedrigere Frequenz zurückzuschalten, so dass z.B. eine Eigenfrequenzumstellung für die 60-Hz-Ladeschaltung nicht erforderlich ist.

Fig. 7 zeigt ein Ausführungsbeispiel der Erfindung, bei dem der Synchronsignaldetektor für die Feststellung der Frequenz mit einer Sägezahnspannung arbeitet, die an einem zweiten Kondensator $C_2$ von 470 nF erzeugt wird. Der Kondensator C, an dem die Sägezahnspannung mit frequenzabhängig eingestellter Amplitude auftritt, ist zwischen Masse (Erde) und einer Ausgangsklemme 121 angeschlossen, der über eine erste Stromquelle 122 von der Batteriespannung +B von 9 V ein konstanter Strom zugeführt wird, mit dem für die niedrigere Frequenz von 50 Hz der Spannungsanstieg während des Hinlaufes erzeugt wird. Für den Hinlaufanstieg bei der höheren Frequenz von 60 Hz ist eine zweite Stromquelle 123 von der Speisequelle +B über eine Diode 124 der ersten Stromquelle 122 parallel geschaltet, wenn ein zwischen der Stromquelle 123 und Masse eingeschalteter npn-Transistor 125 nichtleitend ist. Der Rücklauf der Sägezahnspannung wird mittels einer Entladeschaltung 126 hervorgerufen, die dem Kondensator C parallel liegt und an einer Klemme 127 von Synchronimpulsen gesteuert wird.

Eine dritte Stromquelle 128 ist zwischen der Speisequelle +B und dem andererseits geerdeten Kondensator $C_2$ eingeschaltet. Dadurch wird während des Hinlaufes am Kondensator $C_2$ eine Spannung erzeugt, die von einem unteren Wert $V_{12}$ linear ansteigt. Parallel zum Kondensator $C_2$ liegt die Reihenschaltung einer vierten Stromquelle 129 und der Kollektoremitterstrecke eines npn-Transistors 130, dessen Basis mit der Basis eines weiteren npn-Transistors 131 und über einen Widerstand 132 mit dem Ausgang eines Operationsverstärkers 133 verbunden ist. Die Emitter der Transistoren 130 und 131 liegen an Masse. Zwischen Masse und +B liegt ein Spannungsteiler aus den Widerständen 135, 136, 137 und 138 von 2,2, 2,6, 1,5 und 2,75 kOhm parallel. Dem Widerstand 135 liegt die Kollektoremitterstrecke eines npn-Transistors 140 parallel, dessen Basis von einer Klemme 141 Synchronsignale S zugeführt werden, die z.B. aus Impulsen bestehen, die mit einem Innenwiderstand von 10 kOhm zugeführt werden von einer nicht dargestellten Quelle, deren Spannung im Hinlaufintervall +0,1 V und im Impulsintervall +1 V oder mehr beträgt. An den Abgriff zwischen den Widerständen 136 und 137 ist der Kollektor des Transistors 131 und an den Abgriff zwischen den Widerständen 137 und 138 der invertierende Eingang des Operationsverstärkers 133 angeschlossen. Der andere (direkte) Eingang des Verstärkers 133 steht über die Emitterkollektorstrecke eines npn-Transistors 142 mit der Speisequelle +B in Verbindung, wobei die Basis des Transistors 142 an die Spannung führende Elektrode des Kondensators $C_2$ angeschlossen ist. Der Emitter des Transistors 142, der als Emitterfolger etwa die Kondensatorspannung überträgt, ist ausserdem an die Basis eines Transistors 144 angeschlossen, der mit einem Transistor 145 einen Differenzverstärker mit verbundenen Emittern bildet. In den Kollektorzweigen der Transistoren 144 und 145 liegt eine aus zwei pnp-Transistoren 146 und 147 mit an der Speisequelle +B liegenden Emittern aufgebaute Stromspiegelschaltung, durch die der Leitungszustand des Transistors 144 auf den als Ausgangswiderstand des Transistors 145 wirkenden Transistors 147 übertragen wird.

Der Kollektor des Transistors 145 ist mit der Basis eines, emitterseitig an +B liegenden pnp-Transistors 148 verbunden, dessen Kollektor über einen Widerstand 149 von 45 kOhm an die Basis eines emitterseitig an Masse liegenden npn-Transistors 150 und eines andererseits ebenfalls an Masse liegenden Widerstandes 151 von 20 kOhm angeschlossen ist.

Der Kollektor des Transistors 150 liegt an der Basis eines emitterseitig an Masse angeschlossenen npn-Transistors 152, dessen Kollektor mit der Basis eines npn-Transistors 153 verbunden ist. Der Emitter des Transistors 153 liegt, ebenso wie der Emitter eines weiteren npn-Transistors 154, an Masse. Die Kollektoren der Transistoren 153 und 154 sind über Widerstände 155 bzw. 156 von je 45 kOhm an die verbundenen Emitter der Transistoren 144 und 145 und ausserdem über Widerstände 157 von 17 kOhm bzw. 158 von 15 kOhm mit der Basis des jeweils anderen Transistors verbunden. Die Transistoren 144 und 145 bzw. 153 und 154 in den Alternativstufen führen gemeinsam etwa den gleichen Strom, so dass sie trotz unabhängiger Steuerung in Reihe geschaltet werden können.

Die Basis des Transistors 145 liegt am Abgriff eines Spannungsteilers, der zwischen Masse und +B eingeschaltet ist und aus den Widerständen 161 von 5,95 kOhm und 162 von 3,1 kOhm besteht und eine Spannung von 5,8 V führt. Der Ausgang des Operationsverstärkers 133 ist einerseits mit einer Ausgangsklemme 164 und andererseits über einen Widerstand 165 von 33 kOhm mit der Basis des Transistors 152 verbunden. An der Klemme 164 tritt, ggf. über einen Verstärker, ein während des Rücklaufes positiver Impuls auf, der z.B. zur Dunkelsteuerung einer Bildröhre während des Bildrücklaufes benutzt werden kann.

Die Schaltung nach Fig. 7 arbeitet wie folgt: Durch die Stromquelle 128 wird dem Kondensator $C_2$ ein konstanter Ladestrom zugeführt derart, dass die Spannung von einem unteren Wert $V_{12}$ zeit-

proportional ansteigt. Der Verlauf der Spannung entspricht dann etwa dem der Kurve 111 in Fig. 6, wobei im folgenden Spannungswerte angegeben werden, die denen in Fig. 5 etwa entsprechen und mit um 10 erhöhter Indexzahl bezeichnet werden, so dass $V_2$ in Fig. 6 nun einer Spannung $V_{12}$ entspricht. Diese Spannung wird über den als Emitterfolger wirkenden Transistor 142 auf den direkten Eingang des Verstärkers 133 übertragen. Wenn die Spannung am Kondensator $C_2$ etwa den am Abgriff des zwischen den Widerständen 137 und 138 liegenden Wert $V_{13}$-$v_{be}$ erreicht, wird der Verstärker 133 leitend, und die Transistoren 130 und 131 führen Strom. $v_{be}$ ist die bei leitendem Transistor zwischen Basis und Emitter stehende Spannung von etwa 0,7 V. Durch den Transistor 130 wird so die Stromquelle 129 eingeschaltet, die einen entsprechend der höheren Rücklaufteilheit grösseren Strom zur Entladung von dem Kondensator $C_2$ ableitet. Durch den Transistor 131 werden die Widerstände 135 und 136 kurzgeschlossen derart, dass die Spannung am Abgriff zwischen den Widerständen 137 und 138 von zunächst 6,3 V etwa auf den Wert $V_{12}$-$v_{be}$ von 3,2 V absinkt. Wenn die Spannung am Kondensator $C_2$ den Wert $V_{12}$ erreicht hat, werden der Verstärker 133 und die Transistoren 130 und 131 gesperrt, der Rücklauf endet, und ein neuer Hinlauf wird eingeleitet.

Die Spannung $V_{13}$ wird nur dann erreicht, wenn keine Synchronisierung erfolgt. Mittels eines von der Klemme 141 zugeführten Synchronimpulses S, durch den der Transistor 140 vom nichtleitenden in den leitenden Zustand gebracht wird, wird der Widerstand 135 überbrückt. Dadurch sinkt die Spannung zwischen den Widerständen 137 und 138 ab. Am Ende des Hinlaufes hat die Spannung am Kondensator $C_2$ bereits einen höheren Wert erreicht derart, dass beim Schalten mittels des Synchronimpulses S die Spannung am invertierenden Eingang des Verstärkers 133 soweit abgesenkt wird, dass der Verstärker 133 leitet und der bereits beschriebene Rücklauf einsetzt. Der Synchronimpuls S ist normalerweise kürzer als die durch die Entladung mittels der Stromquelle 129 bedingte Rücklaufzeit. Auch bei längeren Synchronimpulsen wird am Ende des Rücklaufes der Hinlauf wieder eingeschaltet.

Am Anfang der Rücklaufzeit wird von einer Klemme 170, die auch eine Verbindung zu einem anderen, auf dem gleichen Halbleiterkörper integrierten Schaltungsteil darstellen kann, über einen Widerstand 166 von 12 kOhm ein schmaler, z.B. 2 bis 3 μs dauernder, positiver Setzimpuls zugeführt, der z.B. der Vertikalablenkung entnommen ist, dessen Breite klein ist gegenüber der normalen Rücklaufdauer und der z.B. einen Scheitelwert von 5,2 V gegenüber einem Basiswert von 0,2 V besitzt. Die Transistoren 153 und 154 bilden eine selbsthaltende Schaltstufe derart, dass bei einer Öffnung des Transistors 153 durch den erwähnten Setzimpuls vom Schaltungspunkt 170 der Transistor 154 gesperrt wird und am Kollektor des Transistor 153 und damit der Basis des Transistors 125 eine z.B. +0,3 V betragende Spannung auftritt, durch die auch der Transistor 125 gesperrt gehalten wird. Dann fliesst der Strom von der Stromquelle 123 über die Diode 124 gemeinsam mit dem Strom der Quelle 122 zum Kondensator C, und es erfolgt ein schneller Spannungsanstieg, wie er für den 60-Hz-Betrieb erwünscht ist. Der Strom der Quelle 123 beträgt etwa 1/5 des Stromes der Quelle 122, so dass sich der Strom der Quelle 122 zum Summenstrom der Quellen 122 und 123 verhält wie 5:6.

Am Abgriff des Spannungsteilers 161, 162 steht eine Spannung $V_{14}$-$v_{be}$, die zwischen der niedrigeren Spannung $V_{16}$, bei der der Rücklauf der Spannung des Kondensators $C_2$ bei 60 Hz eingeleitet wird, und dem Wert $V_{11}$ liegt, bei dem der Rücklauf am Kondensator $C_2$ bei 50-Hz-Betrieb beginnt. Solange die Spannung am Kondensator $C_2$ niedriger als $V_{14}$ ist, ist der Transistor 144 gesperrt, und am Kollektor des Transistors 145 steht eine niedrige Spannung, durch die die Transistoren 148 und 150 geöffnet werden, so dass der Transistor 152 keinen Strom führt, auch wenn während des Rücklaufes vom Ausgang des Verstärkers 133 über den Widerstand 165 ein positiver Strom zum Verbindungspunkt des Kollektors des Transistors 150 mit der Basis des Transistors 152 fliesst. Die Schaltstufe mit den Transistoren 153 und 154 kann somit in der 60-Hz-Lage stehen bleiben, bzw. sie wird von dem oben beschriebenen Setzimpuls in diese Lage geschaltet.

Wenn jedoch der Synchronimpuls infolge eines 50-Hz-Betriebes erst auftritt, wenn infolge der Spannung am Kondensator $C_2$ über den Emitterfolger 142 der Transistor 144 leitend geworden ist, werden die Transistoren 145, 148 und 150 gesperrt. Der bei Synchronisierung von der Klemme 141 her am Ausgang des Verstärkers 133 auftretende Spannungsanstieg öffnet dann über den Widerstand 165 während der Rücklaufzeit den Transistor 152, wodurch die Wirkung des 60-Hz-Setzimpulses 170 aufgehoben und der Transistor 153 gesperrt wird. Infolgedessen steigt die Kollektorspannung des Transistors 153 an, und der Transistor 125 wird geöffnet derart, dass nunmehr der für den 60-Hz-Betrieb erforderliche Ladestrom der Quelle 123 abgeleitet wird und nur der für den 50-Hz-Betrieb erforderliche Strom der Quelle 122 zum Kondensator C fliesst.

In dieser Schaltung wird in jedem einzelnen Intervall durch den Setzimpuls vom Schaltungspunkt 170 her versucht, den 60-Hz-Betrieb herzustellen. Mittels des Differenzverstärkers 144, 145 wird jedoch, solange die Spannung des Kondensators $C_2$ den durch den Spannungsteiler 161, 162 bedingten Umschaltwert $V_{14}$ übersteigt, diese Zurücksetzung verhindert und durch die Steuerung über den Widerstand 165 der 50-Hz-Betrieb eingestellt, der dann durch die selbsthaltende Ausführung des Schalters mit den Transistoren 153, 154 weiter besteht. Wenn die Synchronimpulse mit einer Frequenz von 60 Hz erscheinen, wird der Transistor 144 nicht geöffnet, die Transistoren 145, 148 und 150 führen Strom derart, dass der Transistor 152 gesperrt ist und der Setzimpuls über den Widerstand 166 die Schaltstufe 153, 154 in die 60-Hz-Lage bringen kann, wo sie dann stehen bleibt.

Auch die in Fig. 7 dargestellte Schaltung kann vorzugsweise überwiegend in integrierter Technik ausgeführt sein.

## Patentansprüche

1. Schaltungsanordnung zum Erzeugen einer Sägezahnspannung an einem Kondensator, der durch einen ersten Strom aufgeladen wird, bis eine erste Schwellenspannung erreicht ist, und der durch einen zweiten Strom entladen wird, bis eine zweite Schwellenspannung erreicht ist, wobei im Zeitpunkt des Erreichens einer Schwellenspannung die Richtung und gegebenenfalls die Stärke des dem Kondensator zugeführten Stromes umgeschaltet wird und wobei der Unterschied zwischen der ersten und der zweiten Schwellenspannung sowie der Auflade- und der Entladestrom die Eigenfrequenz der erzeugten Sägezahnspannung bestimmen, wobei einer der Umschaltzeitpunkte der Kondensatorladung durch zugeführte Synchronsignale mit einer nahezu konstanten Nennwiederholungsfrequenz bestimmbar und damit die Sägezahnspannung durch die Synchronsignale synchronisierbar ist, dadurch gekennzeichnet, dass die Eigenfrequenz der erzeugten Sägezahnspannung ($v_c$) unter dem Einfluss eines automatischen Synchronsignaldetektors (36; 36, 54; 105), der das Vorhandensein und/oder die Frequenz des Synchronsignals prüft, umschaltbar ist.

2. Schaltungsanordnung nach Anspruch 1, dadurch gekennzeichnet, dass durch den Synchronsignaldetektor (36; 36, 54) das Vorhandensein des Synchronsignals festgestellt wird, und dass beim Fehlen des Synchronsignals ein erster Schaltzustand, in dem die Eigenfrequenz der Sägezahnspannung der Nennwiederholungsfrequenz des Synchronsignals nahezu entspricht, und beim Vorhandensein des Synchronsignals ein zweiter Schaltzustand in dem die Eigenfrequenz der Sägezahnspannung niedriger ist als die genannte Nennwiederholungsfrequenz, hergestellt wird.

3. Schaltungsanordnung nach Anspruch 1, dadurch gekennzeichnet, dass die Sägezahnspannung ($v_c$) mit einer Bezugsspannung verglichen wird, wobei im ersten Schaltzustand die Entladung des Kondensators (C) eingeleitet und die Bezugsspannung zur zweiten Schwellenspannung ($V_2$) umgeschaltet wird wenn die Sägezahnspannung die erste Schwellenspannung ($V_1$) erreicht und die Aufladung des Kondensators eingeleitet und die Bezugsspannung zur ersten Schwellenspannung umgeschaltet wird wenn die Sägezahnspannung die zweite Schwellenspannung erreicht.

4. Schaltungsanordnung nach Anspruch 3, dadurch gekennzeichnet, dass der Auflade- bzw. Entladestrom nahezu konstant ist und dass die Differenz zwischen der ersten und der zweiten Schwellenspannung grösser ist im zweiten Schaltzustand als im ersten Schaltzustand.

5. Schaltungsanordnung nach Anspruch 4, dadurch gekennzeichnet, dass im zweiten Schaltzustand der Kondensator beim Erreichen der ersten Schwellenspannung ($V_1$) durch die Sägezahnspannung auf einen neuen Wert der ersten Schwellenspannung, die dritte Schwellenspannung ($V_3$) weiter aufgeladen wird, wobei die Differenz zwischen der dritten und der zweiten Schwellenspannung grösser ist als die Differenz zwischen der ersten und der zweiten Schwellenspannung.

6. Schaltungsanordnung nach Anspruch 5, gekennzeichnet durch einen ersten Transistor (29) zum Entladen des Kondensators (C) und durch einen zweiten Transistor (32) zum Umschalten der Bezugsspannung, wobei der erste und der zweite Transistor unter dem Einfluss des Synchronsignaldetektors (36; 36, 54) im zweiten Zustand in demselben Leitungszustand bleiben wenn die Sägezahnspannung ($v_c$) die erste Schwellenspannung ($V_1$) erreicht.

7. Schaltungsanordnung nach Anspruch 6, dadurch gekennzeichnet, dass der erste (29) und der zweite (32) Transistor vor dem Zeitpunkt der Erreichung der ersten Schwellenspannung ($V_1$) durch die Sägezahnspannung ($v_c$) gesperrt sind und dass ein durch den Synchronsignaldetektor gesteuerter dritter Transistor (34) im zweiten Zustand den ersten und den zweiten Transistor nach dem genannten Zeitpunkt gesperrt hält.

8. Schaltungsanordnung nach Anspruch 3 oder 7, dadurch gekennzeichnet, dass der Synchronsignaldetektor einen vierten Transistor (36) enthält, der beim Erreichen der ersten Schwellenspannung ($V_1$) durch die Sägezahnspannung ($v_c$) im ersten Schaltzustand den dritten Transistor (34) verhindert, den ersten (29) und den zweiten (32) Transistor zu sperren.

9. Schaltungsanordnung nach Anspruch 8, dadurch gekennzeichnet, dass der vierte Transistor (36) beim Auftritt des Synchronsignals den dritten Transistor (34) verhindert, den ersten (29) und den zweiten Transistor (32) zu sperren.

10. Schaltungsanordnung nach Anspruch 8, gekennzeichnet durch einen in eine Steuerleitung des vierten Transistors (36) aufgenommenen weiteren Kondensator (44), der im zweiten Schaltzustand aufgeladen wird wenn die Sägezahnspannung ($v_c$) die erste Schwellenspannung ($V_1$) erreicht, wobei die Spannung am weiteren Kondensator das Schalten des vierten Transistors verursacht, wenn die Sägezahnspannung die dritte Schwellenspannung ($V_3$) erreicht.

11. Schaltungsanordnung nach Anspruch 5, dadurch gekennzeichnet, dass die Sägezahnspannung ($v_c$) mit einer zweiten Bezugsspannung verglichen wird, die im zweiten Schaltzustand der dritten Schwellenspannung ($V_3$) entspricht, wenn die Sägezahnspannung die erste Schwellenspannung ($V_1$) erreicht.

12. Schaltungsanordnung nach Anspruch 3, dadurch gekennzeichnet, dass die Differenz zwischen der ersten und der zweiten Schwellenspannung ($V_1$, $V_2$) nahezu konstant ist und dass der Auflade- bzw. Entladestrom eine geringere Stärke aufweist im zweiten Schaltzustand der Schaltungsanordnung als im ersten Schaltzustand derselben.

13. Schaltungsanordnung nach einem der vorstehenden Ansprüche, dadurch gekennzeichnet, dass die das Synchronsignal erzeugende Quelle (45) in eine Steuerleitung des vierten Transistors (36) aufgenommen ist.

14. Schaltungsanordnung nach einem der vorstehenden Ansprüche, dadurch gekennzeichnet, dass die erste bzw. zweite Bezugsspannung beim Auftritt der Synchronimpulse einen zwischen der ersten ($V_1$) und der zweiten Schwellenspannung ($V_2$) liegenden Wert ($V'_1$) annimmt.

15. Schaltungsanordnung nach einem der vorstehenden Ansprüche, dadurch gekennzeichnet, dass die Synchronsignalquelle ein Impulsformer (IMP) ist, der das von einem einen Teil einer indirekten Synchronisationsschleife bildenden Oszillator ($OSC_1$) erzeugte Signal in Impulse umwandelt, von denen jeder Impuls eine phasengeregelte Flanke hat und zwar abhängig von der Belastung an einer Stufe (H), die die erzeugte Sägezahnspannung zugeführt bekommt, welche Flanke die Schaltungsanordnung direkt synchronisiert.

16. Schaltungsanordnung nach Anspruch 1, dadurch gekennzeichnet, dass mittels des Synchronsignaldetektors (105) festgestellt wird, ob die Frequenz der Synchronimpulse (S) einem ersten niedrigeren oder einem zweiten höheren Wert entspricht und dass beim zweiten Frequenzwert der Aufladestrom und ggf. der Entladestrom des Kondensators (C) erhöht wird derart, dass bei beiden Frequenzen die Amplitude der Sägezahnspannung ($v_c$) etwa gleich gross ist.

17. Schaltungsanordnung nach Anspruch 16, dadurch gekennzeichnet, dass das Verhältnis der zwei Werte des Aufladestromes dem Verhältnis der Frequenzen entspricht.

18. Schaltungsanordnung nach Anspruch 16 oder 17, gekennzeichnet durch eine Sägezahnspannung konstanter Steigung, deren Rücklauf durch die Synchronsignale (S) eingeleitet wird, wobei der Sägezahn bei der zweiten Frequenz einen ersten Amplitudenwert bzw. bei der zweiten Frequenz einen höheren Amplitudenwert erreicht, und wobei eine Umschaltstufe (107) den Betrieb bei der höheren Frequenz einstellt, wenn der Grenzwert nicht überschritten wird und dass die Umschaltstufe den Betrieb bei niedrigerer Frequenz einstellt, wenn der Grenzwert überschritten wird.

19. Schaltungsanordnung nach Anspruch 18, dadurch gekennzeichnet, dass in dem zwischen Ende des Hinlaufes und dem Anfang des Rücklaufes liegenden Zeitpunkt ($t_4$) in jeder Periode die Frequenzeinstellung erfolgt.

20. Schaltungsanordnung nach einem der Ansprüche 18 oder 19, gekennzeichnet durch Impulse zur Frequenzeinstellung am Anfang des Rücklaufes, wobei am Anfang des Rücklaufes ein schmaler, z.B. 2 bis 3 µs dauernder, Setzimpuls für die Umschaltung in den Betrieb bei höherer Frequenz auftritt.

21. Schaltungsanordnung nach Anspruch 20, gekennzeichnet durch einen während der Rücklaufzeit auftretenden Impuls (an 164) zur Umschaltung in den Betrieb bei niedrigerer Frequenz, wobei der kürzere Setzimpuls (von 170) bei Auftreten des längeren Setzimpulses (an 164) durch letzteren unterdrückt wird.

22. Schaltungsanordnung nach einem der Ansprüche 12 oder 16 bis 21, dadurch gekennzeichnet, dass die für den höheren Ladestrom erforderliche Stromquelle (123) über eine Diode (124) mit dem Kondensator (C) verbunden ist und dass zwischen dem Verbindungspunkt der Stromquelle (123) und der Diode (124) einerseits und dem anderen, z.B. an Masse liegenden, Anschluss des Kondensators (C) andererseits ein Schalter (125) liegt, der stromleitend ist, wenn dem Kondensator (C) der niedrigere Strom (von 122) zugeführt wird.

23. Schaltungsanordnung nach Anspruch 20, gekennzeichnet durch eine bistabile Kippstufe (153 bis 158) zur Frequenzumschaltung.

24. Schaltungsanordnung nach Anspruch 1, 16 oder 17, dadurch gekennzeichnet, dass bei Einstellung auf die niedrigere Frequenz der Umschaltschwellwert bei einer Sägezahnamplitude ($V_4$) liegt, die unterhalb des bei der niedrigeren Frequenz normalerweise auftretenden Wertes liegt, und dass der Umschaltschwellwert bei der Einstellung auf den höheren Frequenzwert bei einer Sägezahnamplitude ($V_5$) am Rücklaufanfang liegt, die merklich oberhalb des bei der höheren Frequenz normalerweise auftretenden Wertes liegt (Fig. 6).

## Claims

1. A circuit arrangement for generating a sawtooth-shaped voltage across a capacitor which is charged by a first current until a first threshold voltage is reached, and discharged by a second current until a second threshold voltage is reached, the direction and, possibly, the intensity of the current applied to the capacitor being changed-over at the instant a threshold voltage is reached, the difference between the first and the second threshold voltage as well as the charging and the discharging currents determining the free-running frequency of the sawtooth voltage produced, at least one of the change-over instants of the capacitor charging operation being determinable by means of applied synchronizing signals having a substantially constant nominal repetition frequency and the sawtooth voltage consequently being synchronizable by means of the synchronizing signals, characterized in that the free-running frequency of the generated sawtooth voltage ($v_c$) is switchable under the influence of an automatic synchronizing signal detector (36; 36, 54; 105), which detects the presence and/or the frequency of the synchronizing signal.

2. A circuit arrangement as claimed in Claim 1, characterized in that the presence of the synchronising signal is detected by the synchronizing signal detector (36; 36, 54) and in that in the absence of the synchronizing signal a first switching state, in which the free-running frequency of the sawtooth voltage is substantially equal to the nominal repetition frequency is effected, and that in the presence of the synchronizing signal a second switching state, in which the free-running frequency of the sawtooth voltage is lower than said nominal repetition frequency is effected.

3. A circuit arrangement as claimed in Claim 1, characterized in that the sawtooth voltage ($v_c$) is compared with a reference voltage, whereby in the first switching state the discharge of the capacitor (C) is initiated and the reference voltage is switched to the second threshold voltage ($V_2$) when the sawtooth voltage reaches the first threshold voltage ($V_1$) and charging of the capacitor is initiated and the reference voltage is switched to the first threshold voltage when the sawtooth voltage reaches the second threshold voltage.

4. A circuit arrangement as claimed in Claim 3, characterized in that the charging and discharging current, respectively is substantially constant and that the difference between the first and the second threshold voltages is larger in the second switching state than in the first switching state.

5. A circuit arrangement as claimed in Claim 4, characterized in that in the second switching state the capacitor when the first threshold voltage ($V_1$) is reached is further charged by the sawtooth voltage to a new value of the first threshold voltage, the third threshold voltage ($V_3$), the difference between the third and the second threshold voltages being larger than the difference between the first and the second threshold voltages.

6. A circuit arrangement as claimed in Claim 5, characterized by a first transistor (29) for discharging the capacitor (C) and a second transistor (32) for changing over the reference voltage, the first and the second transistors remaining in the second state under the influence of the synchronizing signal detector (36; 36, 54) in the same conduction state when the sawtooth voltage ($v_c$) reached the first theshold voltage ($V_1$).

7. A circuit arrangement as claimed in Claim 6, characterized in that the first (29) and the second (32) transistor are non-conducting prior to the instant at which the first threshold voltage ($V_1$) is reached by the sawtooth voltage ($v_c$) and that a third transistor (34) which is controlled by the synchronizing signal detector maintains in the second state the first transistor and the second transistor in the non-conducting state after the above-mentioned instant.

8. A circuit arrangement as claimed in Claim 3 or 7, characterized in that the synchronizing signal detector comprises a fourth transistor (36) which when the first threshold voltage ($V_1$) is reached by the sawtooth ($v_c$) prevents in the first switching state the third transistor (34) from cutting off the first (29) and the second (32) transistors.

9. A circuit arrangement as claimed in Claim 8, characterized in that at the occurrence of the synchronizing signal the fourth transistor (36) prevents the third transistor (34) from cutting off the first (29) and the second (32) transistors.

10. A circuit arrangement as claimed in Claim 8, characterized by a further capacitor (44) which is included in a control conductor of the fourth transistor (36) and which is charged in the second switching state when the sawtooth voltage ($v_c$) reaches the first threshold voltage ($V_1$), the voltage at the further capacitor causing the fourth transistor to switch when the sawtooth voltage reaches the third threshold voltage ($V_3$).

11. A circuit arrangement as claimed in Claim 5, characterized in that the sawtooth voltage ($v_c$) is compared with a second reference voltage which in the second switching state is equal to the third threshold voltage ($V_3$) when the sawtooth voltage reaches the first threshold voltage ($V_1$).

12. A circuit arrangement as claimed in Claim 3, characterized in that the difference between the first and the second threshold voltages ($V_1$, $V_2$) is substantially constant and that the charging and discharging current, respectively has a lower intensity in the second switching state of the circuit arrangement than in the first switching state thereof.

13. A circuit arrangement as claimed in any of the preceding Claims, characterized in that the source (45) which generates the synchronizing signal is included in a control conductor of the fourth transistor (36).

14. A circuit arrangement as claimed in any of the preceding Claims, characterized in that the first and the second reference voltage, respectively assumes a value ($V'_1$) which is located between the first ($V_1$) and the second ($V_2$) threshold voltages at the occurrence of the synchronizing pulses.

15. A circuit arrangement as claimed in any of the preceding Claims, characterized in that the synchronizing signal source is a pulse shaper (IMP) which converts the signal produced by an oscillator ($OSC_1$), which forms part of an indirect synchronization loop into pulses, each pulse having an edge whose phase is controlled in dependence on the load of a stage (H) to which the generated sawtooth voltage is applied, said edge directly synchronizing the circuit arrangement.

16. A circuit arrangement as claimed in Claim 1, characterized in that it is detected by means of the synchronizing signal detector (105) whether the frequency of the synchronizing pulses (S) corresponds with a first, lower or a second, higher value and in that at the second frequency value the charging current and, possibly, the discharging current of the capacitor (C) is increased so that at both frequencies the amplitude of the sawtooth voltage ($v_c$) is approximately equally large.

17. A circuit arrangement as claimed in Claim 16, characterized in that the ratio between the two values of the charging current corresponds with ratio of the frequencies.

18. A circuit arrangement as claimed in Claim 16 or 17, characterized by a sawtooth voltage having a constant slope, whose flyback is initiated by the synchronizing signal (S), the sawtooth reaching at the second frequency a first amplitude value and at the second frequency a higher amplitude value, respectively, a switching stage (107) adjusting the operation at the higher frequency when the limit value is not exceeded and the switching stage adjusting the operation at a lower frequency, when the limit value is exceeded.

19. A circuit arrangement as claimed in Claim 18, characterized in that at the instant ($t_4$) located between the end of the trace and the start of the flyback the frequency adjustment is effected in each period.

20. A circuit arrangement as claimed in one of the Claims 18 or 19, characterized by pulses for frequency adjustment at the beginning of the flyback, a narrower setting pulse of a duration of, for example, 2 to 3 $\mu$s occuring at the start of the flyback for the change-over to the operation at a higher frequency.

21. A circuit arrangement as claimed in Claim 20, characterized by a pulse occuring (at 164) during the flyback period for a change-over to the operation at a lower frequency, the shorter setting pulse (from 170) being suppressed at the occurrence of the longer setting pulse (at 164) by the latter.

22. A circuit arrangement as claimed in any of the Claims 12 or 16 to 21, characterized in that the current source (123) required for the higher charging current is connected to the capacitor (C) via a diode (124) and in that between the junction of the current source (123) and the diode (124) on the one hand and the other terminal of the capacitor (C), which terminal is connected to, for example, ground, on the other hand there is a switch (125) which carries current when the lower current is applied (from 122) to the capacitor (C).

23. A circuit arrangement as claimed in Claim 20, characterized by a bistable trigger stage (153 to 158) for the purpose of changing over the frequency.

24. A circuit arrangement as claimed in Claim 1, 16 or 17 characterized in that at the adjustment to the lower frequency the change-over threshold value is located at a sawtooth amplitude ($V_4$) which is below the value which normally occurs at the lower frequency, and that at the change-over threshold value at the adjustment to the higher frequency value is located at the beginning of the flyback at a sawtooth amplitude ($V_5$) which is significantly above the value which normally occurs at the higher frequency (Fig. 6).

## Revendications

1. Montage de circuit pour la production d'une tension en dents de scie dans un condensateur qui est chargé par un premier courant jusqu'à ce qu'une première tension de seuil soit atteinte, et qui est déchargé par un deuxième courant jusqu'à ce qu'une deuxième tension de seuil soit atteinte, étant entendu que, au moment où une tension de seuil est atteinte, la direction et, le cas échéant, l'intensité du courant fourni au condensateur sont inversées et que les différences entre la première et la deuxième tension de seuil ainsi qu'entre le courant de charge et celui de décharge déterminent la fréquence propre de la tension en dents de scie produite, un des points d'inversion de la charge du condensateur pouvant être déterminé par des signaux de snychronisation d'une fréquence de répétition nominale à peu près constante qui y sont appliqués et la tension en dents de scie pouvant être ainsi synchronisé par les signaux de synchronisation, caractérisé en ce que la fréquence propre de la tension en dents de scie ($v_c$) produite peut être commutée à l'intervention d'un détecteur de signal de synchronisation automatique (36; 36, 54; 105), qui vérifie la présence et/ou la fréquence du signal de synchronisation.

2. Montage de circuit suivant la revendication 1, caractérisé en ce que la présence du signal de synchronisation est constatée par le détecteur de synchronisation (36; 36, 54) et, en cas d'absence du signal de synchronisation, est établi un premier état de commutation dans lequel la fréquence propre de la tension en dents de scie correspond approximativement à la fréquence de répétition nominale du signal de synchronisation, tandis que, en cas de présence du signal de synchronisation, est établi un deuxième état de commutation dans lequel la fréquence propre de la tension en dents de scie est inférieure à ladite fréquence de répétition nominale.

3. Montage de circuit suivant la revendication 1, caractérisé en ce que la tension en dents de scie ($v_c$) est comparée à une tension de référence, étant entendu que, dans le premier état de commutation, la décharge du condensateur (C) s'amorce et la tension de référence est commutée vers la deuxième tension de seuil ($V_2$) lorsque la tension en dents de scie atteint la première tension de seuil ($V_1$) et que la charge du condensateur s'amorce et la tension de référence est commutée vers la première tension de seuil lorsque la tension en dents de scie atteint la deuxième tension de seuil.

4. Montage de circuit suivant la revendication 3, caractérisé en ce que le courant de charge ou de décharge est approximativement constant et la différence entre la première et la deuxième tension de seuil est plus grande dans le deuxième état de commutation que dans le premier.

5. Montage de circuit suivant la revendication 4, caractérisé en ce que, dans le deuxième état de commutation, au moment où la première tension de seuil ($V_1$) est atteinte, le condensateur est chargé par la tension en dents de scie à une nouvelle valeur de la première tension de seuil, la troisième tension de seuil ($V_3$), la différence entre la troisième et la deuxième tension de seuil étant supérieure à la différence entre la première et la deuxième.

6. Montage de circuit suivant la revendication 5, caractérisé par un premier transistor (29) pour décharger le condensateur (C) et par un deuxième transistor (32) pour commuter la tension de référence, le premier et le deuxième transistor restant dans le même état de conduction, à l'intervention du détecteur de signal de synchronisation (36; 36, 54) dans le deuxième état, lorsque la tension en dents de scie ($v_c$) atteint la première tension de seuil ($V_1$).

7. Circuit suivant la revendication 6, caractérisé en ce que le premier transistor (29) et le deuxième transistor (32) sont bloqués par la tension en dents de scie ($v_c$) avant le moment où la première tension de seuil ($V_1$) est atteinte et un troisième transistor (34) commandé par le détecteur de signal de synchronisation maintient dans le deuxième état le premier et le deuxième transistor bloqués après ledit moment.

8. Montage de circuit suivant l'une des revendications 3 ou 7, caractérisé en ce que le détecteur de signal de synchronisation comporte un quatrième transistor (36) qui, lorsque la première tension de seuil ($V_1$) est atteinte par la tension en dents de scie ($v_c$) dans le premier état de commutation, empêche le troisième transistor (34) de bloquer le premier transistor (29) et le deuxième transistor (32).

9. Montage de circuit suivant la revendication 8, caractérisé en ce que le quatrième transistor (36) empêche le troisième transistor (34), lors de la sortie du signal de synchronisation, de bloquer le premier transistor (29) et le deuxième transistor (32).

10. Montage de circuit suivant la revendication 8, caractérisé par un autre condensateur (44) connecté dans un conducteur de commande du quatrième transistor (36), qui est chargé dans le deuxième état de commutation lorsque la tension en dents de scie ($v_c$) atteint la première tension de seuil ($V_1$), de sorte que la tension présente dans l'autre condensateur provoque la commutation du quatrième condensateur, lorsque la tension en dents de scie atteint la troisième tension de seuil ($V_3$).

11. Montage de circuit suivant la revendication 5, caractérisé en ce que la tension en dents de scie ($v_c$) est comparée à une deuxième tension de référence qui, dans le deuxième état de commutation, correspond à la troisième tension de seuil ($V_3$) lorsque la tension en dents de scie atteint la première tension de seuil ($V_1$).

12. Montage de circuit suivant la revendication 3, caractérisé en ce que la différence entre la première et la deuxième tension de seuil ($V_1$, $V_2$) est approximativement constante et le courant de charge ou de décharge présente une intensité plus faible dans le deuxième état de commutation du montage de circuit que dans le premier.

13. Montage de circuit suivant l'une des revendications précédentes, caractérisé en ce que la source (45) produisant le signal de synchronisation est connectée dans un conducteur de commande du quatrième transistor (36).

14. Montage de circuit suivant l'une des revendications précédentes, caractérisé en ce que la première ou la deuxième tension de référence acquiert, lors de la sortie de l'impulsion de synchronisation, une valeur située entre la première tension de seuil ($V'_1$) et la deuxième tension de seuil ($V_2$).

15. Montage de circuit suivant l'une quelconque des revendications précédentes, caractérisé en ce que la source de signal de synchronisation est un conformateur d'impulsions (IMP) qui convertit le signal produit par un oscillateur ($OSC_1$) faisant partie d'une boucle de synchronisation indirecte en impulsions, chaque impulsion comportant un flanc réglé par la phase, et ce en fonction de la charge d'un étage (H) qui reçoit la tension en dents de scie produite, ce flanc synchronisant directement le montage de circuit.

16. Montage de circuit suivant la revendication 1, caractérisé en ce que le détecteur de signal de synchronisation (105) constate si la fréquence des impulsions de synchronisation (S) correspond à une première valeur inférieure ou à une deuxième valeur supérieure et, pour la deuxième valeur de fréquence, le courant de charge et, le cas échéant, le courant de décharge du condensateur (C) est augmenté d'une première telle que, pour les deux fréquences, l'amplitude de la tension en dents de scie ($v_c$) soit à peu près égale.

17. Montage de circuit suivant la revendication 16, caractérisé en ce que le rapport des deux valeurs du courant de charge correspond au rapport des fréquences.

18. Montage de circuit suivant l'une des revendications 16 ou 17, caractérisé par une montée constante de la tension en dents de scie, dont le retour est amorcé par les signaux de synchronisation (S), la dent de scie, pour la deuxième fréquence, atteignant une première valeur d'amplitude et, pour la deuxième fréquence, une valeur d'amplitude plus élevée, et un étage de commutation (107) réglant le fonctionnement à la fréquence supérieure lorsque la valeur limite n'est pas dépassée et à la fréquence inférieure, lorsque le valeur limite est dépassée.

19. Montage de circuit suivant la revendication 18, caractérisé en ce que le réglage de la fréquence s'effectue au moment ($t_4$) compris entre la fin de l'aller et le début du retour dans chaque période.

20. Montage de circuit suivant l'une des revendications 18 ou 19, caractérisé par des impulsions pour régler la fréquence au début du retour, étant entendu que, au début du retour, une impulsion de positionnement étroite, par exemple d'une durée de 2 à 3 $\mu$s, est produite pour la commutation lors du fonctionnement à la fréquence supérieure.

21. Montage de circuit suivant la revendication 20, caractérisé par une impulsion (en 164) apparaissant pendant le temps de retour pour commuter le fonctionnement pour la fréquence inférieure, l'impulsion de positionnement plus courte (de 170) étant supprimée lors de l'apparition de l'impulsion de positionnement plus longue (en 164) par cette dernière.

22. Montage de circuit suivant l'une des revendications 12 ou 16 à 21, caractérisé en ce que la source de courant (123) nécessaire pour le courant de charge supérieur est connectée, par l'intermédiaire d'une diode (124), au condensateur (C) et, entre le point de jonction de la source de courant (123) et de la diode (124), d'une part, et l'autre connexion du condensateur (C), par exemple mise à la masse, d'autre part, se trouve un commutateur (125) qui est conducteur lorsque le condensateur (C) reçoit le courant inférieur (122).

23. Montage de circuit suivant la revendication 20, caractérisé par un étage de bascule bistable (153 à 158) pour la commutation de fréquence.

24. Montage de circuit suivant l'une des revendications 1, 16 ou 17, caractérisé en ce que, lors d'un réglage sur la fréquence inférieure, la valeur de seuil de commutation a une amplitude de dent de scie ($V_4$) qui se situe en dessous de la valeur apparaissant normalement pour la fréquence inférieure, et la valeur de seuil de commutation, pour le réglage sur la fréquence supérieure, a une amplitude de dent de scie ($V_5$) correspondant à celle du début du retour qui est nettement supérieure à celle de la valeur apparaissant normalement pour la fréquence supérieure (fig. 6).

FIG.1

FIG.2

0 011 899

FIG.3

FIG.4

23

FIG.5

FIG.6

FIG.7